(19) Europäisches Patentamt
European Patent Office
Office européen des brevets

(11) **EP 1 306 698 A1**

(12) **EUROPEAN PATENT APPLICATION**

(43) Date of publication:
**02.05.2003 Bulletin 2003/18**

(51) Int Cl.[7]: **G02B 5/08**, G02B 5/10, G21K 1/06

(21) Application number: **01125639.3**

(22) Date of filing: **26.10.2001**

(84) Designated Contracting States:
**AT BE CH CY DE DK ES FI FR GB GR IE IT LI LU MC NL PT SE TR**
Designated Extension States:
**AL LT LV MK RO SI**

(71) Applicant: **NIKON CORPORATION**
**Tokyo 100-0005 (JP)**

(72) Inventors:
• **Shiraishi, Masayuki, Nikon Corporation**
**Tokyo 100 (JP)**

• **Murakami, Katsuhiko, Nikon Corporation**
**Tokyo 100 (JP)**
• **Kondo, Hiroyuki, Nikon Corporation**
**Tokyo 100 (JP)**
• **Kandaka, Noriaki, Nikon Corporation**
**Tokyo 100 (JP)**

(74) Representative: **Meddle, Alan Leonard**
**Forrester & Boehmert**
**Pettenkoferstrasse 20-22**
**80336 München (DE)**

(54) **Multilayer reflective mirrors for EUV, wavefront-aberration-correction methods for the same, and EUV optical systems comprising the same**

(57)    Multilayer mirrors are disclosed for use especially in "Extreme Ultraviolet" ("soft X-ray," or "EUV") optical systems. Each multilayer mirror includes a stack of alternating layers of a first material and a second material, respectively, to form an EUV-reflective surface. The first material has a refractive index substantially the same as a vacuum, and the second material has a refractive index that differs sufficiently from the refractive index of the first material to render the mirror reflective to EUV radiation. The wavefront profile of EUV light reflected from the surface is corrected by removing ("machining" away) at least one surficial layer of the stack in selected region(s) of the surface of the stack. Machining can be performed such that machined regions have smooth tapered edges rather than abrupt edges. The stack can include first and second layer groups that allow the unit of machining to be very small, thereby improving the accuracy with which wavefront-aberration correction can be conducted. Also disclosed are various at-wavelength techniques for measuring reflected-wavelength profiles of the mirror. The mirror surface can include a cover layer of a durable material having high transparency and that reduces variations in reflectivity of the surface caused by machining the selected regions.

FIG. 19

EP 1 306 698 A1

# Description

## Field

The disclosure pertains to microlithography (transfer of a fine pattern by an energy beam to a substrate that is "sensitive" to exposure by the energy beam). Microlithography is a key technology used in the manufacture of microelectronic devices such as integrated circuits, displays, magnetic pickup heads, and micromachines. More specificically, the disclosure pertains to microlithography in which the energy beam is a "soft X-ray" beam (also termed an "extreme ultraviolet" or "EUV" beam), to EUV optical systems in general, and to optical components (specifically reflective elements) used in EUV optical systems.

## Background

As the size of circuit elements in microelectronic devices (e.g., integrated circuits) has continued to decrease, the inability of optical microlithography (microlithography performed using ultraviolet light) to achieve satisfactory resolution of pattern elements is increasingly apparent. Tichenor et al., *Proc. SPIE* **2437:**292 (1995).

Hence, intense effort currently is being expended to develop a practical "next-generation" microlithography technology that can achieve substantially greater resolution than obtainable with optical microlithography. A principal candidate next-generation microlithography involves the use of extreme ultraviolet ("EUV"; also termed "soft X-ray") radiation as the energy beam. The EUV wavelength range currently being investigated is 11-14 nm, which is substantially shorter than the wavelength range (150-250 nm) of conventional "vacuum" ultraviolet light used in current state-of-the-art optical microlithography. EUV microlithography has the potential to yield an image resolution of less than 70 nm, which is beyond the capacity of conventional optical microlithography.

In the EUV wavelength range, the refractive index of substances is very close to unity. Hence, in this wavelength range, conventional optical components that rely upon refraction cannot be used. Consequently, optical elements for use with EUV are limited to reflective elements, such as glancing-incidence mirrors that exploit total reflection from a material having a refractive index slightly less than unity, and "multilayer" mirrors. The latter achieve a high overall reflectivity by aligning and superposing the phases of weakly reflected light from the respective interfaces of multiple thin layers, wherein the weakly reflected fields add constructively at certain angles (producing a Bragg effect). For example, at a wavelength near 13.4 nm, a Mo/Si multilayer mirror (comprising alternatingly stacked molybdenum (Mo) and silicon (Si) layers) exhibits a reflectivity of 67.5% of normal-incidence EUV light. Similarly, at a wavelength near 11.3 nm, a Mo/Be multilayer mirror (comprising alternatingly stacked Mo and beryllium (Be) layers) exhibits a reflectivity of 70.2% of normal-incidence EUV light. See, e.g., Montcalm, *Proc. SPIE* **3331:**42 (1998).

An EUV microlithography system principally comprises an EUV source, an illumination-optical system, a reticle stage, a projection-optical system, and a substrate stage. For the EUV source, a laser-plasma light source, a discharge-plasma light source, or an external source (e.g., electron-storage ring or synchrotron) can be used. The illumination-optical system normally comprises: (1) a grazing-incidence mirror that reflects EUV radiation, from the source, incident at a grazing angle of incidence on the reflective surface of the mirror, (2) multiple multilayer mirrors of which the reflective surface is a multilayer film, and (3) a filter that only admits the passage of EUV radiation of a prescribed wavelength. Thus, the reticle is illuminated with EUV radiation of a desired wavelength,

Because no known materials can transmit EUV radiation to any useful extent, the reticle is a "reflection" reticle rather than a conventional transmissive reticle as used in optical microlithography. EUV radiation reflected from the reticle enters the projection-optical system, which focuses a reduced (demagnified) image of the illuminated portion of the reticle pattern on the substrate. The substrate (usually a semiconductor "wafer") is coated on its upstream-facing surface with a suitable resist so as to be imprintable with the image. Because EUV radiation is attenuated by absorption by the atmosphere, the various optical systems, including the reticle and substrate, are contained in a vacuum chamber evacuated to a suitable vacuum level (e.g., $1 \times 10^{-5}$ Torr or less).

The projection-optical system typically comprises multiple multilayer mirrors. Because the maximal reflectivity of a multilayer mirror to EUV radiation currently achievable is not 100%, to minimize the loss of EUV radiation during propagation through the projection-optical system, the system should contain the fewest number of multilayer mirrors as possible. For example, a projection-optical system consisting of four multilayer mirrors is described in Jewell and Thompson, U.S. Patent No. 5,315,629, and Jewell, U.S. Patent No. 5,063,586, and a projection-optical system consisting of six multilayer mirrors is described in Williamson, Japan *Kôkai* Patent Publication No. *Hei* 9-211332 and U.S. Patent No. 5,815,310.

In contrast to a refractive optical system through which the light flux propagates in one direction, in a reflective optical system, the light flux typically propagates back-and-forth from mirror to mirror as the flux propagates through the system. Due to the need to avoid diminution of the light flux by the multilayer mirrors as much as possible, it is difficult to increase the numerical aperture (NA) of a reflective optical system. For example, in a conventional four-mirror optical system, the maximum obtainable NA is 0.15. In a conventional six-mirror optical system, a considerably higher NA (e.g., 0.25) can be obtained. Normally, the number of multilayer mirrors in the projection-optical system is an even number, which allows the reticle stage and substrate stage to be disposed on opposite sides of the projection-optical system.

In view of the constraints discussed above, in an EUV projection-optical system aberrations must be corrected using a limited number of reflective surfaces. Due to the limited ability of a small number of spherical-surface mirrors in achieving adequate correction of aberrations, the multilayer mirrors in the projection-optical system normally have aspherical reflective surfaces. Also, the projection-optical system normally is configured as a "ring-field" system in which aberrations are corrected only in the vicinity of a prescribed image height. With such a system, to transfer the entire pattern on the reticle onto the substrate, exposure is conducted by moving the reticle stage and substrate stage at respective scanning velocities that differ from each other by the demagnification factor of the projection-optical system.

The EUV projection-optical system described above is "diffraction-limited" and cannot achieve its specified performance level unless the wavefront aberration of EUV radiation propagating through the system can be made sufficiently small. An allowable value for the wavefront aberration for diffraction-limited optical systems normally is less than or equal to 1/14 of the wavelength used, in terms of a root-mean-square (RMS) value, according to Maréchal's criterion. Bom and Wolf, *Principles of Optics*, 7th ed., Cambridge University Press, p. 528 (1999). The Maréchal's condition is necessary to achieve a Strehl intensity of 80% or greater (the ratio between maximum point-image intensities for an optical system having aberrations versus an aberration-free optical system). For optimal performance, the projection-optical system for an actual EUV microlithography apparatus desirably exhibits aberrations sufficiently reduced so as to fit within this criterion.

As noted above, in EUV microlithography technology that is the object of intensive research efforts, an exposure wavelength mainly in the range of 11 nm to 13 nm is used. With respect to the wavefront aberration (WFE) in an optical system, the maximal profile error (FE) that can be allowed per multilayer mirror is expressed as follows:

$$FE = (WFE)/2/(n)^{1/2} \qquad (1)$$

wherein n denotes the number of multilayer mirrors in the optical system. The reason for dividing by 2 is that, in a reflective optical system, both the incident light and the reflected light are subject to profile errors; hence, an error of twice the profile error is applied to the wavefront aberration. In a diffraction-limited optical system, the profile error (FE) allowable per multilayer mirror can be expressed in terms of the wavelength $\lambda$ and the number (n) of multilayer mirrors:

$$FE=\lambda/28/(n)^{1/2} \qquad (2)$$

At $\lambda$ = 13 nm the value of FE is 0.23 run RMS for an optical system consisting of four multilayer mirrors, and 0.19 nm RMS for an optical system consisting of six multilayer mirrors.

Unfortunately, it is extremely difficult to fabricate such high-precision aspherical multilayer mirrors, which is a major factor currently hampering efforts to commercialize EUV microlithography. To date, the maximum mechanical accuracy with which aspherical multilayer mirrors can be fabricated is 0.4 to 0.5 nm RMS. Gwyn, *Extreme Ultraviolet Lithography White Paper,* EUV LLC, p. 17 (1998). Thus, commercial realization of EUV microlithography still requires substantial improvements in machining technology and measurement techniques for aspherical multilayer mirrors.

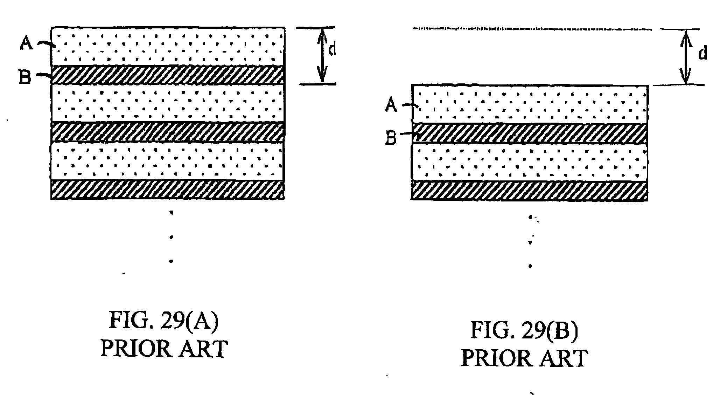

Recently, an important technique was disclosed offering prospects of correcting sub-nanometer profile errors of a multilayer mirror. Yamamoto, *7th International Conference on Synchrotron Radiation Instrumentation*, Berlin, Germany, August 21-25, 2000, POS 2-189. In this technique the surface of a multilayer mirror is locally "shaved" one layer-pair at a time. The basic principles of this technique are described with reference to FIGS. 29(A)-29(B). Referring first to FIG. 29 (A), the removal of a pair of layers is considered. The depicted surface is a multilayer film fabricated by alternatingly stacking respective layers of two substances, denoted "A" and "B" (e.g., silicon (Si) and molybdenum (Mo)), at a fixed period length d. In FIG. 29(B), the uppermost pair of layers A, B (representing one period length d) has been removed. In FIG. 29(A) the optical path length OP, through a pair of film layers A, B having a period length d, of a normal-incidence ray is expressed by the equation:

$$OP = (n_A)(d_A) + (n_B)(d_B) \qquad (3)$$

wherein $d_A$ and $d_B$ denote the respective thicknesses of the layers A,B, such that $d_A + d_B = d$. The terms $n_A$ and $n_B$ denote the respective refractive indices of the substances A and B, respectively.

In FIG. 29(B), the optical path length of the region, having a thickness d, from which one pair of layers A, B has been removed from the topmost surface, is given by OP' = nd, wherein n denotes the refractive index of a vacuum (n = 1). Thus, removing the topmost pair of layers A, B from the multilayer film changes the optical path length over which an incident light beam propagates; this is optically equivalent to correcting the reflected wavefront profile of the changed portion of the multilayer mirror. By removing the topmost pair of layers A, B, the change in optical path length (i.e., the change in surface profile) can be given by:

$$\Delta = OP' - OP \qquad (4)$$

As noted above, in the EUV wavelength region, the refractive index of substances is very close to unity. Thus, $\Delta$ is small, which offers the prospect of making accurate wavefront-profile corrections using this method.

For example, consider a Mo/Si multilayer mirror irradiated at a wavelength of 13.4 nm. At direct (normal) incidence, let d = 6.8 nm, $d_{Mo}$ = 2.3 nm, and $d_{Si}$ = 4.5 nm. At $\lambda$ = 13.4 nm, $n_{Mo}$ = 0.92 and $n_{Si}$ = 0.998. Calculating optical path lengths yields OP = 6.6 nm, OP' = 6.8 nm, and $\Delta$ = 0.2 nm. By performing a conventional surface-machining step that removes the topmost pair of layers of Mo and Si (collectively having a thickness of 6.8 nm) wavefront-profile corrections of 0.2 nm can be made. In the case of a Mo/Si multilayer film, because the refractive index of the Si layer is close to unity, changes in the optical path length mainly depend upon the presence or absence of a Mo layer rather than the respective Si layer. Therefore, when removing a surficial pair of layers from a Mo/Si multilayer film, accurate control of the thickness of the Si layer is unnecessary. For example, a $d_{Si}$ = 4.5 nm allows a layer-removal machining step to be stopped in the middle of the Si layer. Thus, by performing layer-removal machining at an accuracy of a few nanometers, it is possible to achieve a wavefront-profile correction in the order of 0.2 nm.

The reflectivity of a multilayer mirror generally increases with the number of stacked layers, but the increase is asymptotic. I.e., upon forming a certain number of layers (e.g., about 50 layer pairs), the reflectivity of the multilayer structure becomes "saturated" at a particular constant and exhibits no further increase with additional layer pairs. Hence, with a multilayer mirror having a sufficient number of layer pairs to yield a saturated reflectivity, no significant change in reflectivity results when a few surficial layers are removed from the multilayer film.

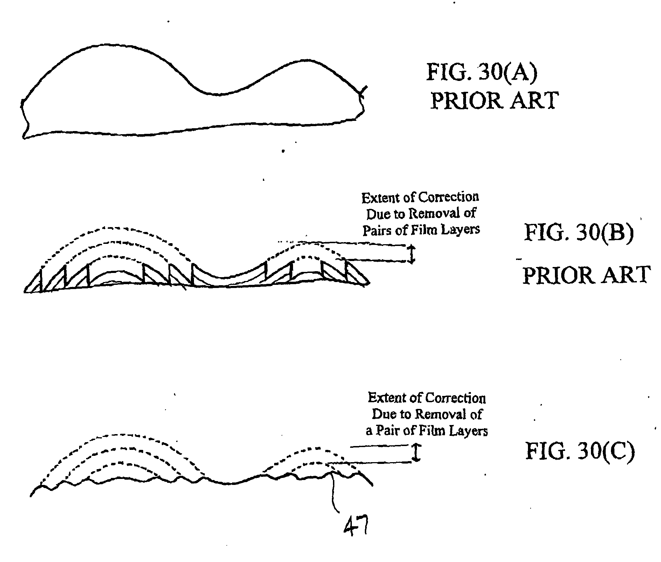

The Yamamoto method (by removing one or more surftcial pairs of layers from selected regions of the multilayer film) yields a discontinuous correction of the wavefront profile of light reflected from the mirror. For example, consider a transverse profile of a reflective-surface of a multilayer mirror as shown in FIG. 30 (A). Performing the Yamamoto method results in removing selected portions of surficial layer pairs (FIG. 30(B)). However, note the abrupt edges of affected layer pairs.

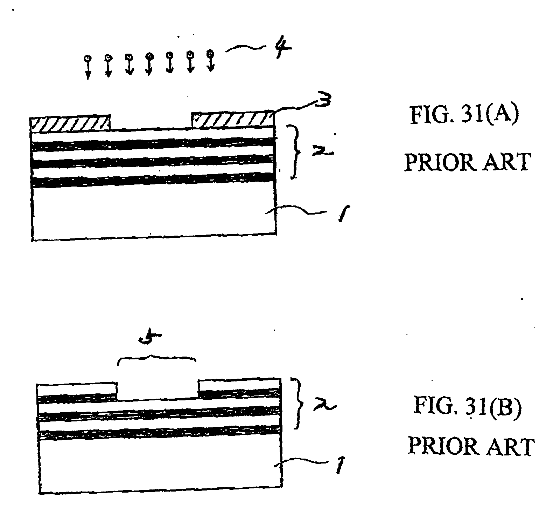

According to Yamamoto, to remove a selected region of a surficial pair of layers, a mask technique is used, as shown in FIG. 31(A), which depicts a mirror substrate 1 on which a multilayer film 2 has been formed. A mask 3 is defined in a layer of a suitable photoresist applied directly on the surface of the multilayer film 2. To form the mask 3, the resist is exposed to define regions corresponding to selected regions of the multilayer film 2 in which a surficial pair of layers is to be removed. The unexposed resist is removed, leaving the patterned mask 3. Regions of the surface of the multilayer film 2 unprotected by the mask 3 are subjected to sputter-etching using an ion beam 4 or the like to remove the surficial pair of layers selectively. After sputter-etching, the remaining mask 3 is removed, yielding a mirror structure in which portions 5 of the surficial pair of layers are removed (FIG. 31(B)).

For clarity, in FIGS. 29(A)-29(B), 30(A)-30(B), and 31(A)-31(B), the depicted number of layers is fewer than the number that would be used in an actual multilayer mirror.

Corrections of a reflected wavefront performed according to Yamamoto produces on-surface discontinuous phases of reflected waves, especially at the edges of regions in which a surficial pair of layers has been removed. This results in a jagged (discontinuous) cross-sectional profile of the reflection wavefront A discontinuous reflection wavefront can produce unexpected phenomena, such as diffraction, that degrades the performance of the optical system and seriously compromises any prospect of achieving a desired high resolution. As a result, a correction of less than 0.2 nm cannot be achieved.

In other words, with a target profile error of 0.19 - 0.23 nm RMS for an EUV optical system (see Equation (2), above), the unit of machining according to Yamamoto is in the order of 0.2 nm, as noted above. Hence, because the Yamamoto technique is inadequate for achieving the target profile error of the optical system, there is a need for methods that achieve more accurate machining of the multilayer-mirror surface.

Furthermore, when removing selected local regions of surficial layers as described above, the local regions can be shaved unequally by the ion beam. As a result, the machined surface can include portions in which substance A is exposed and other portions in which substance B is exposed, wherein the thickness of these exposed regions is not uniform. In these situations, the reflectivity of EUV radiation from the mirror surface exhibits a distribution and this is not constant over the surface of the multilayer mirror. Generally, a substance such as Mo is the topmost layer. If the thickness of the exposed Mo layer is approximately equal to the thickness of each of the other Mo layers in the periodic multilayer structure, then an increase in the thickness of Mo increases the reflectivity. On the other hand, if Si is the topmost layer, then the reflectivity decreases with an increase in the number of Si layers. Furthermore, in regions in which Mo is exposed, the exposed Mo tends to oxidize, which reduces the EUV reflectivity of the regions.

Hence, whenever local machining is conducted on a Mo/Si multilayer film (normally having a pre-machining uniform in-surface reflectivity distribution), such that the multilayer film surface is machined unevenly, an uneven in-surface reflectivity of the multilayer film surface results. If the multilayer mirror is used in a reduction projection-exposure system using EUV radiation, if an in-surface reflectivity distribution is created on a multilayer mirror used in such an optical system, then illumination irregularities in the exposure field and non-uniform values of Δ can result, which reduces exposure performance. Therefore, there is a need for methods for reducing the in-surface reflectivity distribution for a multilayer film on which localized machining has been conducted.

In addition, accurate surficial machining requires that required corrections be determined accurately in advance of machining. Fizeau interferometers using visible light (e.g., He-Ne laser light) have been used widely for performing measurements of surface profiles. The accuracy of such measurements, however, usually is inadequate for meeting modem accuracy requirements. Also, a conventional visible-light interferometer cannot be used for measuring a surface "corrected" by localized removal of material from the multilayer-film surface. This is because the profile of a reflected visible light wavefront is different from the profile of a reflected wavefront at an EUV wavelength.

## Summary

In view of the shortcomings of conventional methods and multilayer mirrors produced thereby, the present invention in its various aspects provides multilayer mirrors that can produce a reflected wavefront having reduced aberrations than conventional multilayer mirrors, without reducing reflectivity of the mirror to EUV radiation.

According to a first aspect of the invention, methods are provided for making a multilayer mirror. In an embodiment of the methods, a stack of alternatingly superposed layers of first and second materials is formed on a surface of a mirror substrate. The first and second materials have different respective refractive indices with respect to EUV radiation. Wavefront aberrations of EUV radiation reflected from a surface of the multilayer mirror are reduced by a method including measuring (at an EUV wavelength at which the multilayer mirror is to be used) a profile of a reflected wavefront from the surface to obtain a map of the surface. The map indicates regions targeted for surficial removal of one or more layers of the multilayer film necessary to reduce wavefront aberrations of EUV light reflected from the surface. Based on the map, at least one surficial layer in each of the indicated regions is removed.

In this embodiment, the measurement step is performed "at wavelength" (i.e., at the EUV wavelength at which the mirror will be used). Desirable measurement techniques utilize a diffractive optical element, and can be any of the following: shearing interferometry, point-diffraction interferometry, the Foucalt test, the Ronchi test, and the Hartmann Test. The measurements can be performed of EUV light reflected from an individual multilayer mirror, or can be performed of EUV light transmitted through an EUV optical system including at least one subject multilayer mirror.

In an example of the latter method, the multilayer mirror is assembled into an EUV optical system that is transmissive to EUV radiation at a wavelength at which the multilayer mirror is to be used. At that EUV wavelength the profile of a wavefront transmitted through the EUV optical system is measured to obtain a map of the surface indicating regions targeted for surficial removal of one or more layers of the multilayer film necessary to reduce wavefront aberrations of EUV light reflected from the surface. Based on the map, one or more surficial layers are removed in the indicated regions.

During the layer-forming step, the stack can be formed with multiple layer pairs each including a first layer (comprising, e.g., Mo) and a second layer (comprising, e.g., Si). To provide the mirror with good reflectivity to EUV radiation, each layer pair typically has a period in a range of 6 to 12 nm.

After forming the multilayer mirror, the mirror can be incorporated into an EUV optical system, which in turn can be incorporated into an EUV microlithography system.

According to another aspect of the invention, multilayer mirrors are provided that are reflective to incident EUV radiation. An embodiment of such a mirror comprises a mirror substrate and a thin-film layer stack formed on a surface of the mirror substrate. The stack includes multiple thin-film first layer groups and multiple thin-film second layer groups alternately superposed relative to each other in a periodically repeating manner. Each first layer group includes at least one sublayer of a first material having a refractive index to EUV light substantially equal to the refractive index of a vacuum, and each second layer group includes at least one sublayer of a second material and at least one sublayer of a third material. The first and second layer groups in this embodiment are alternately superposed relative to each other in a periodically repeating configuration. The second and third materials have respective refractive indices that are substantially similar to each other but that are different from the refractive index of the first material sufficiently such that the stack is reflective to incident EUV light. The second and third materials have differential reactivities to sublayer-removal conditions such that a first sublayer-removal condition will preferentially remove a sublayer of the second material without substantial removal of an underlying sublayer of the third material. Similarly, a second sublayer-removal condition will preferentially remove a sublayer of the third material without substantial removal of an underlying sublayer of the second material. Typically, the second material can be Mo, the third material can be Ru, and the first material can be Si.

Each second layer group can comprise multiple sublayer sets each comprising a sublayer of the second material and a sublayer of the third material. The sublayers in this configuration are alternatingly stacked to form the second layer group.

In another embodiment of methods according to the invention, on a surface of a mirror substrate, a thin-film layer stack (including multiple thin-film first layer groups and multiple thin-film second layer groups alternatingly superposed relative to each other) are formed in a periodically repeating configuration. Each first layer group includes at least one sublayer of a first material having a refractive index to EUV light substantially equal to the refractive index of a vacuum, and each second layer group includes at least one sublayer of a second material and at least one sublayer of a third material. The first and second layer groups are alternatingly superposed relative to each other in a periodically repeating configuration. The second and third materials have respective refractive indices that are substantially similar to each other but different from the refractive index of the first material sufficiently such that the stack is reflective to incident EUV light. The second and third materials have differential reactivities to sublayer-removal conditions such that a first sublayer-removal condition will preferentially remove a sublayer of the second material without substantial removal of an underlying sublayer of the third material, and a second sublayer-removal condition will preferentially remove a sublayer of the third material without substantial removal of an underlying sublayer of the second material. In selected regions of a surficial second layer group, one or more sublayers of the surficial second layer group are selectively removed so as to reduce wavefront aberrations of EUV radiation reflected from the surface. Removing one or more sublayers of the surficial second layer group can yield a phase difference in EUV components reflected from the indicated regions, compared to EUV light reflected from other regions in which no sublayers are removed or a different number of sublayers are removed. Removing one or more sublayers of the surficial second group layer can comprise selectively exposing the indicated regions to one or both the first and second sublayer-removal conditions as required to achieve an indicated change in a reflected wavefront profile from the surface.

This method embodiment can further include the step of measuring a profile of a reflected wavefront from the surface to obtain a map of the surface indicated the regions targeted for removal of the one or more sublayers of the surficial second layer group.

One or more multilayer mirrors produced according to this method embodiment can be assembled into an EUV optical system, which in turn can be assembled into an EUV microlithography system.

Another embodiment of a multilayer mirror reflective to incident EUV radiation comprises a mirror substrate and a thin-film layer stack formed on a surface of the mirror substrate. The stack includes superposed first and second groups of multiple thin-film layers. Each of the first and second groups comprises respective first and second layers alternatingly superposed relative to each other in a respective periodically repeating manner. Each first layer comprises a first material having a refractive index to EUV light substantially equal to the refractive index of a vacuum, and each second layer comprises a second material having a refractive index that is different from the refractive index of the first material sufficiently such that the stack is reflective to incident EUV light. The first and second groups have similar respective period lengths but have different respective thickness ratios of individual respective first and second layers. The first material desirably is Si, and the second material desirably is Mo and/or Ru. The respective period lengths are within a range of 6 to 12 nm.

In this embodiment, if $\Gamma_1$ denotes the ratio of the respective second-layer thickness to the period length of the first group, and $\Gamma_2$ denotes the ratio of the respective second-layer thickness to the period length of the second group, then desirably $\Gamma_2 < \Gamma_1$. $\Gamma_2$ can be established such that, whenever a reflection-wavefront correction is made to the mirror by removing one or more surficial layers of the mirror, the magnitude of the correction per unit thickness of the second material is as prescribed.

In another embodiment of a method for making a multilayer mirror for use in an EUV optical system, on a surface of a mirror substrate a stack is formed that includes a first group of multiple superposed thin-film layers and a superposed second group of multiple superposed thin-film layers. Each of the first and second groups comprises respective first and second layers alternatingly superposed on each other in a respective periodically repeating configuration. Each first layer comprises a first material having a refractive index to EUV light substantially equal to the refractive index of a vacuum, and each second layer comprises a second material having a refractive index that is different from the refractive index of the first material sufficiently such that the stack is reflective to incident EUV light. The first and second groups have similar respective period lengths but have different respective thickness ratios of individual respective first and second layers. In selected regions of the surface of the stack, one or more layers of the surficial second group are removed so as to reduce wavefront aberrations of EUV light reflected from the surface.

This method can include the step of measuring a profile of a reflected wavefront from the surface to obtain a map of the surface indicating regions targeted for removal of one or more layers of the surficial second layer group as necessary to reduce wavefront aberrations of EUV light reflected from the surface. In the stack-forming step and during formation of the second group of layers, the second group can be formed having a number of respective second layers such that, during the layer-removal step, removing a surficial second layer results in a maximal phase correction of a reflection wavefront from the mirror. As noted above, the first material desirably is Si, and the second material desirably is Mo and/or Ru, wherein the respective period lengths are in a range of 6 to 12 nm.

This method can further comprise the step, after the layer-removal step, of forming a surficial layer of a reflectivity-correcting material, having a refractive index to EUV light substantially equal to the refractive index of a vacuum, at least in regions in which reflectivity has changed due to removal of one or more surficial layers during the layer-removal step. The reflectivity-correcting material desirably comprises Si.

Yet another embodiment of a multilayer mirror comprises a mirror substrate, a multilayer stack, and a cover layer. The stack includes alternatingly superposed layers of first and second materials formed on a surface of the mirror substrate. The first and second materials have different respective refractive indices with respect to EUV radiation, wherein selected regions of the multilayer mirror have been subjected to surficial-layer "shaving" so as to correct a reflected-wavefront profile from the mirror. The cover layer is formed on the surface of the stack. The cover layer is of a material exhibiting a persistent and consistently high transmissivity to electromagnetic radiation of a specified wavelength. The cover layer extends over regions of the surface of the stack including the selected regions and has a substantially uniform thickness. The stack desirably has a period length in the range of 6 to 12 nm. The first material desirably is Si or an alloy including Si, the second material desirably is Mo or an alloy including Mo, and the material of the cover layer desirably is Si or an alloy including Si. The cover layer desirably has a thickness of 1 to 3 nm or a thickness sufficient to add 1-3 nm to a period length of a surficial pair of layers including a respective layer of the first material and a respective layer of the second material.

In yet another embodiment of a method for making a multilayer mirror for use in an EUV optical system, a thin-film layer stack is formed on a surface of a mirror substrate. The stack includes multiple layers of a first material and multiple layers of a second material alternating superposed relative to one another in a periodically repeating manner. The first and second materials have different respective refractive indices with respect to EUV radiation. One or more surficial layers are removed from selected surficial regions of the multilayer mirror so as to correct a reflected-wavefront profile from the mirror. A cover layer is formed on a surface of the stack. As noted above, the cover layer is of a material exhibiting a persistent and consistently high transmissivity to electromagnetic radiation of a specified wavelength. The cover layer extends over regions of the surface of the stack including the selected surficial regions and has a substantially uniform thickness. Desirably, the stack is formed with a period length in a range of 6 to 12 nm. Further desirably, the first material is Si or an alloy including Si, the second material is Mo or an alloy including Mo, and the material of the cover layer is Si or an alloy including Si. The cover layer desirably is formed at a thickness of 1 to 3 nm or a thickness sufficient to add 1-3 nm to a period length of a surficial pair of layers including a respective layer of the first material and a respective layer of the second material.

In yet another embodiment of a method for making a multilayer mirror, on a surface of a mirror substrate a stack is formed of alternating layers of first and second materials having different respective refractive indices with respect to EUV radiation. The stack has a prescribed period length. In selected regions of the surface of the stack, one or more surficial layer pairs are removed as required to correct a reflected-wavefront profile of the surface in a manner such that edges of remaining corresponding layer pairs located outside the selected regions have a smoothly graded topology. The layer-pair-removal step can be, for example, small-tool corrective machining, ion-beam processing, or chemical-vapor machining. Desirably, the first material comprises Si and the second material comprises a material such as Mo and/or Ru. The period length desirably is 6 to 12 nm.

The invention also encompasses multilayer mirrors produced using any of the various method embodiments within the scope of the invention, as well as EUV optical systems that comprise a multilayer mirror made by such a method or otherwise is configured according to any of the mirror embodiments within the scope of the invention. The invention also encompasses EUV microlithography systems that include an EUV optical system within the scope of the invention. The multilayer mirrors, as well as EUV optical systems and EUV microlithography systems comprising the same, are especially suitable for use with EUV radiation in the 12-15 nm wavelength range.

The foregoing and additional features and advantages of the invention will be more readily apparent from the following detailed description, which proceeds with reference to the accompanying drawings.

## Brief Description of the Drawings

FIG. 1(A) is an exemplary contour diagram of a reflective surface, indicating zones where corrections, computed from reflected wavefront-profile measurements, are to be made and the magnitude of the corrections.

FIG. 1(B) is an elevational section along the line A-A in FIG. 1(A).

FIG. 1(C) is the elevational section of FIG. 1(B) after making the computed corrections.

FIG. 2 schematically depicts shearing interferometry as used for measuring the profile of a wavefront reflected by a multilayer mirror.

FIG. 3 schematically depicts point-diffraction interferometry as used for measuring the profile of a reflected wavefront from a multilayer mirror.

FIG. 4 is a plan view of a PDI plate as used in the scheme shown in FIG. 3.

FIG. 5 schematically depicts measuring the profile of a reflected wavefront from a multilayer mirror using the Foucault Test.

FIG. 6 schematically depicts measuring the profile of a reflected wavefront from a multilayer mirror using the Ronchi Test.

FIG. 7 is a plan view of a grating used in the Ronchi Test scheme shown in FIG. 6.

FIG. 8 schematically depicts measuring the profile of a reflected wavefront from a multilayer mirror using the Hartmann Test.

FIG. 9 is a plan view of a plate used in the Hartmann Test scheme shown in FIG. 8.

FIG. 10 schematically depicts shearing interferometry as used for measuring the profile of a wavefront transmitted by an EUV optical system.

FIG. 11 schematically depicts measuring the profile of a wavefront transmitted by an EUV optical system using point-diffraction interferometry.

FIG. 12 schematically depicts measuring the profile of a wavefront transmitted by an EUV optical system using the Foucault Test.

FIG. 13 schematically depicts measuring the profile of a wavefront transmitted by an EUV optical system using the Ronchi Test.

FIG. 14 schematically depicts measuring the profile of a wavefront transmitted by an EUV optical system using the Hartmann Test.

FIGS. 15(A)-15(B) are respective elevational sections comparing wavefront-correction machining for a multilayer mirror, performed according to an aspect of the invention (FIG. 15(A)), compared to a conventional wavefront-correction method.

FIGS. 16(A)-16(B) are respective elevational sections showing a multilayer-film-surface machining method based upon small-tool corrective machining.

FIGS. 17(A)-17(B) are respective elevational sections showing a multilayer-film-surface machining method based upon ion-beam machining.

FIGS. 18(A)-18(B) are respective elevational sections showing a multilayer-film-surface machining method based upon chemical-vapor machining (CVM).

FIG. 19 is an elevational section of a multilayer mirror on which surface machining has been performed, according to an embodiment of the invention, to reduce wavefront aberration.

FIG. 20 is an elevational section of a multilayer mirror on which surface machining has been performed, according to another embodiment of the invention, to reduce wavefront aberration.

FIG. 21 is a plot of reflectivity and changes $\Delta$ in optical path length as respective functions of $\Gamma$ of a conventional multilayer film.

FIG. 22 is a schematic elevational section of an embodiment of a multilayer mirror according to the invention.

FIG. 23 is a plot of reflectivity and changes $\Delta$ in optical path length as respective functions of $\Gamma$ of a multilayer mirror according to an embodiment of the invention.

FIG. 24 is a plot of the number (N) of layers and the reflectivity (R) of a second multilayer film applied to an upper layer of a multilayer mirror, according to an embodiment of the invention.

FIGS. 25(A)-25(B) are respective elevational sections of a multilayer film before and after, respectively, being conventionally machined to control the phase of the reflection wavefront.

FIG. 26 is an elevational section of a multilayer film having a reduced in-surface reflectivity distribution, according to an embodiment of the invention,

FIG. 27 is a plot of exemplary reductions in the in-surface reflectivity distribution as achieved using the method shown in FIG. 26.

FIG. 28 is a schematic diagram of an EUV microlithography apparatus that includes multilayer mirrors corrected according to an aspect of the invention.

FIGS. 29(A)-29(B) are respective elevational sections depicting the principles of reflection-wavefront-phase correction achieved by removing a surficial layer pair of a multilayer film, according to conventional practice.

FIGS. 30(A)-30(B) are respective elevational sections showing a reflection wavefront before and after, respectively, performing wavefront-profile correction according to conventional practice.

FIG. 30(C) is an elevational section that, when compared to FIG. 30(B), depicts the improved correction of wavefront profile achievable by an aspect of the invention.

FIGS. 31(A)-31(B) are respective elevational sections showing a conventional multilayer-film surface-machining method performed using ion-beam machining.

## Detailed Description

Various aspects of the invention are described below in the context of representative embodiments, which are not intended to be limiting in any way.

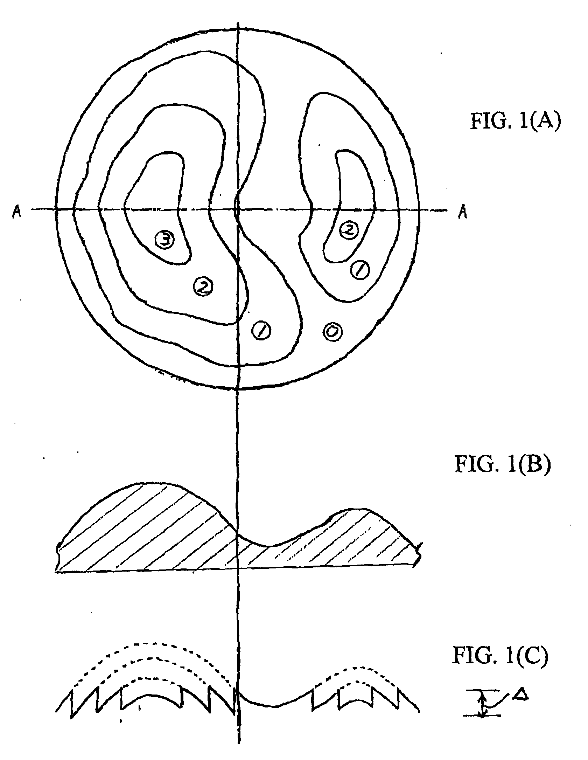

To determine an amount of correction to be made to a multilayer mirror, a reflected wavefront from the mirror is measured at the wavelength at which the multilayer mirror is to be used. General aspects of determining where on the mirror surface corrections should be made are depicted in FIGS. 1(A)-1(C), and various measurement techniques with which a profile such as the exemplary profile shown in FIG. 1(A) can be obtained are described below.

The profile shown in FIG. 1(A) is a contour profile presented in two dimensions. The contour interval (distance between adjacent contour lines) represents an amount of surface correction $\Delta$ associated with removing one surficial layer-pair from the multilayer film of the mirror. By way of example, for a Mo/Si multilayer film as discussed in the Background section above, $\Delta$ = 0.2 nm at $\lambda$ = 13.4 nm and d = 6.8 nm (wherein $d_{Mo}$ = 2.3 nm, $d_{Si}$ = 4.5 nm). An elevational sectional profile along the line A-A is shown in FIG. 1(B). To correct this profile, surficial portions of the multilayer film having the greatest height, according to the contour map of FIG. 1(A), are removed layer by layer. In FIG. 1(A), the numbers associated with the contours denote the number of layer-pairs to be removed in the respective regions to achieve a surface-profile correction equivalent to 0.2 nm (at d = 6.8 nm and $\lambda$ = 13.4 nm). For example, the middle left-hand contour represents an area in which three layer-pairs should be removed from the surface of the multilayer film. FIG. 1 (C) depicts the elevational profile after correction, in which the "pv" (peak-to-valley) dimension is reduced to $\Delta$.

Measurement of Reflected Wavefront Profile

Any of various techniques can be used to measure the profile of a reflected wavefront, at a specified wavelength, from a multilayer mirror. These techniques are summarized below.

Shearing Interferometry

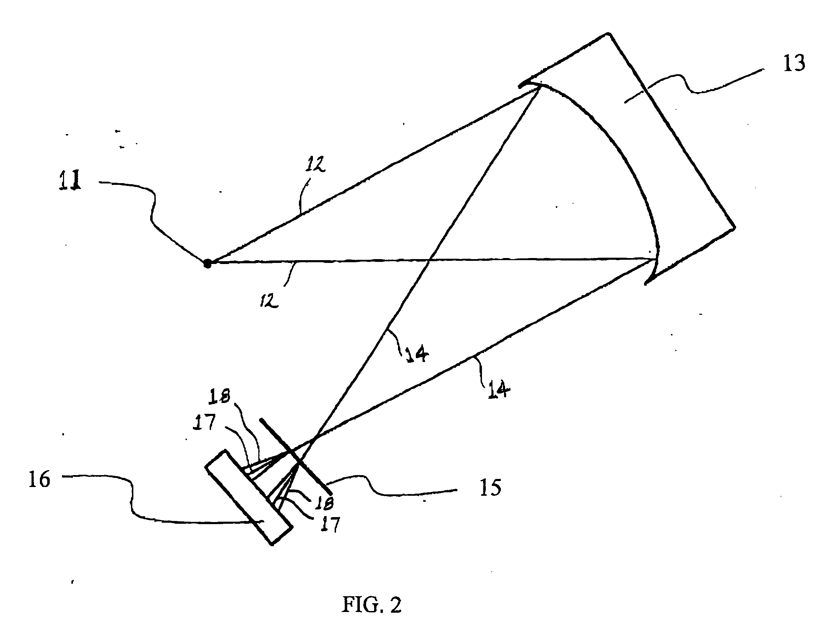

Shearing interferometry is shown in FIG. 2, in which EUV rays 12 from an EUV source 11 are reflected by a multilayer mirror 13. The reflected wavefront 14 is split up by a transmission diffraction grating 15, and is incident to an image detector 16. Zero-order rays 17 (propagating along a straight line from the grating 15) and $\pm$ first-order diffracted rays 18 (propagating along respective paths that are altered by diffraction) are shifted laterally so as to overlap each other on the image detector 16. The resulting interference pattern is recorded. The interference pattern includes surface-slope data, and the profile of the reflected wavefront from the multilayer mirror 13 can be computed by performing mathematical integration of this slope data. The light source 11 may be, for example, a synchrotron-radiation light source, a laser- plasma light source, an electric-discharge-plasma light source, or an X-ray laser. The image detector 16 may be, for example, an imaging plate or a CCD (charge-coupled device) that is responsive to incident EUV radiation.

Point-Diffraction Interferometry

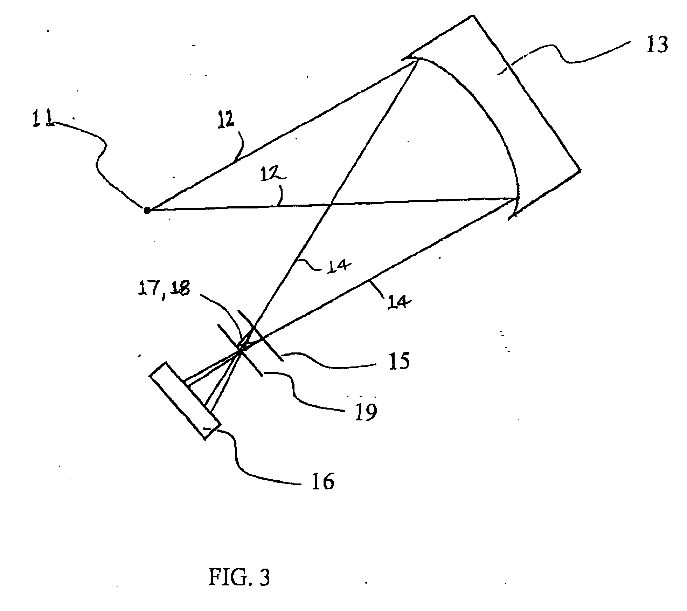

Point-diffraction interferometry (PDI) may be used for at-wavelength measurement of the reflected wavefront. This technique as applied to a multilayer mirror is shown in FIG. 3, in which rays 12 of EUV light from a source 11 are reflected from the multilayer mirror 13. The reflected wavefront 14 is split up by a transmission diffraction grating 15. A PDI plate 19 is placed at the point of convergence of the diffracted rays 17, 18.

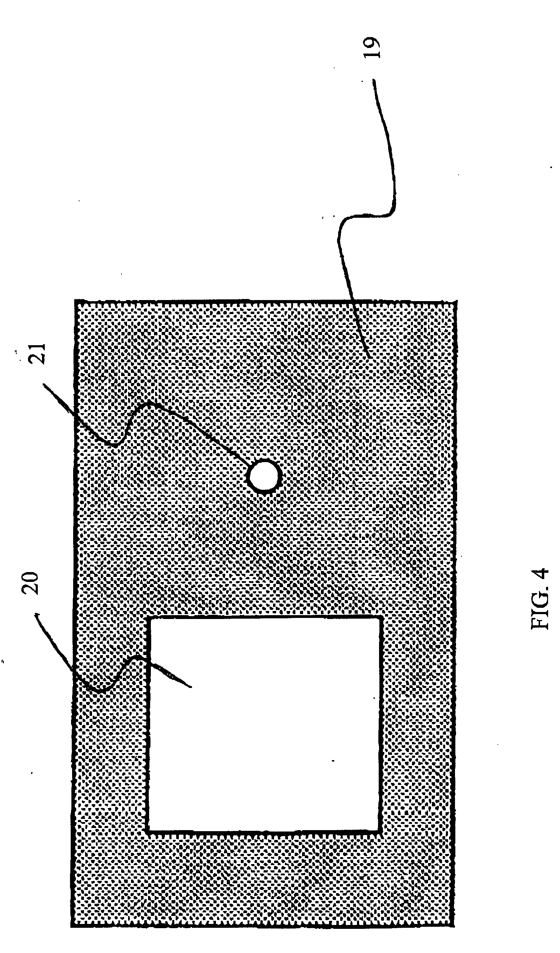

As shown in FIG. 4, the PDI plate 19 defines a relatively large aperture 20 and a relatively small aperture ("pinhole") 21. The pitch of the diffraction grating 15 and the axial separation of the large aperture 20 from the pinhole 21 are such that, of the light of the wavefront split up by the diffraction grating 15, the zero-order light 17 passes through the pinhole 21, and the first-order diffracted light 18 passes through the large aperture 20. Rays passing through the pinhole 21 are diffracted to form a spherical wavefront having no aberrations, while the wavefront passing through the relatively large aperture 20 includes the aberrations of the reflective surface of the multilayer mirror 13. The interference pattern formed by these overlapping wavefronts is monitored at the image detector 16. The profile of the reflected wavefront from the multilayer mirror 13 is computed from the interference pattern. Since the source 11 must provide EUV light capable of exhibiting a large amount of interference, sources such as a synchrotron-radiation source or an X-ray laser are especially desirable. The image detector 16 may be, for example, an imaging plate or a CCD responsive to EUV light.

Foucalt Method

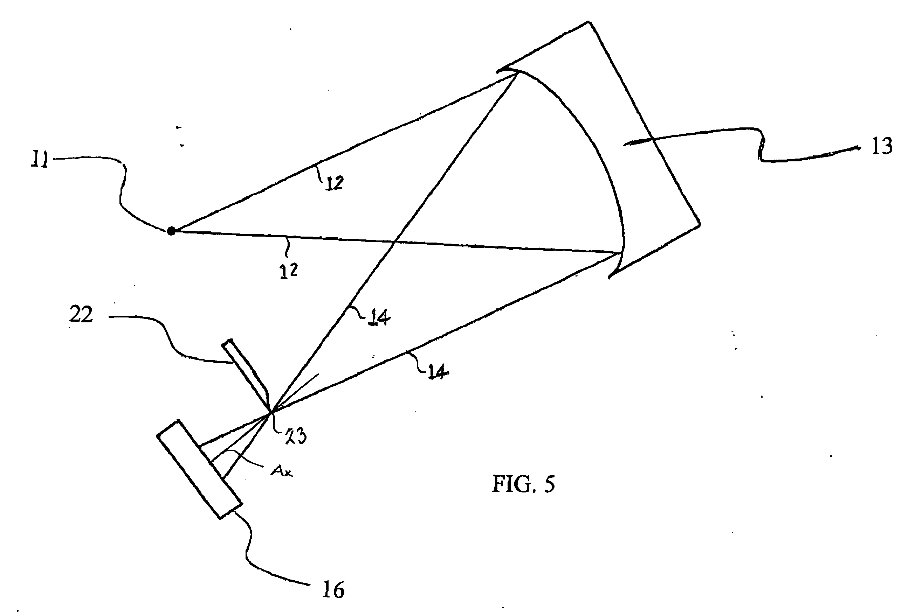

The Foucault method is shown in FIG. 5, in which EUV light 12 from an EUV light source 11 is reflected by the multilayer mirror 13 to an image detector 16. A knife edge 22 is situated at the point of convergence 23 of the reflected rays 14. The profile of the reflected wavefront from the multilayer mirror 13 is computed from detected changes in the pattern received by the image detector 16 as the knife edge 22 is moved in a direction normal to the optical axis. The source 11 may be, for example, a synchrotron-radiation light source, a laser-plasma light source, an electric-discharge-plasma light source, or an X-ray laser. The image detector 16 may be, for example, an imaging plate or a CCD responsive to EUV light.

Ronchi Test

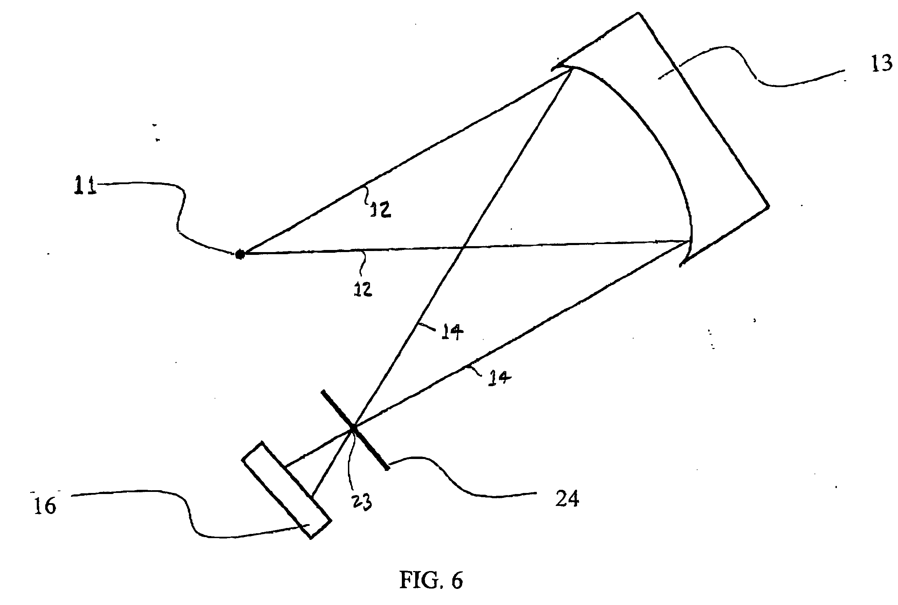

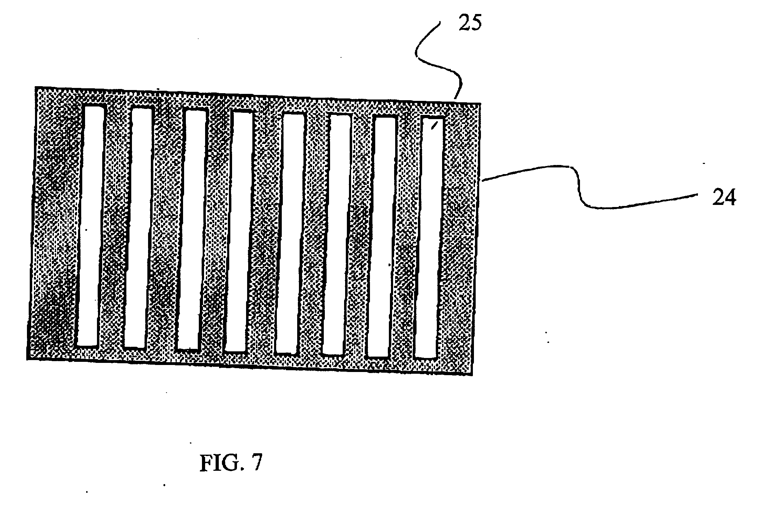

The Ronchi Test method is depicted in FIG. 6, in which EUV light from an EUV light source 11 is reflected by the multilayer mirror 13 to an image detector 16. A Ronchi grating 24 is situated at the point of convergence 23 of the reflected rays 14. As shown in FIG. 7, the Ronchi grating 24 typically is an opaque plate defining multiple oblong rectangular apertures 25. The resulting line pattern formed on the image detector 16 is affected by aberrations of the multilayer mirror 13. The profile of the reflected wavefront from the multilayer mirror 13 is computed from an analysis of the pattern. The light source 11 may be, for example, a synchrotron-radiation light source, a laser-plasma light source, an electric-discharge-plasma light source, or an X-ray laser. The image detector 16 can be, for example, an imaging plate or a CCD responsive to EUV light.

Hartman Test

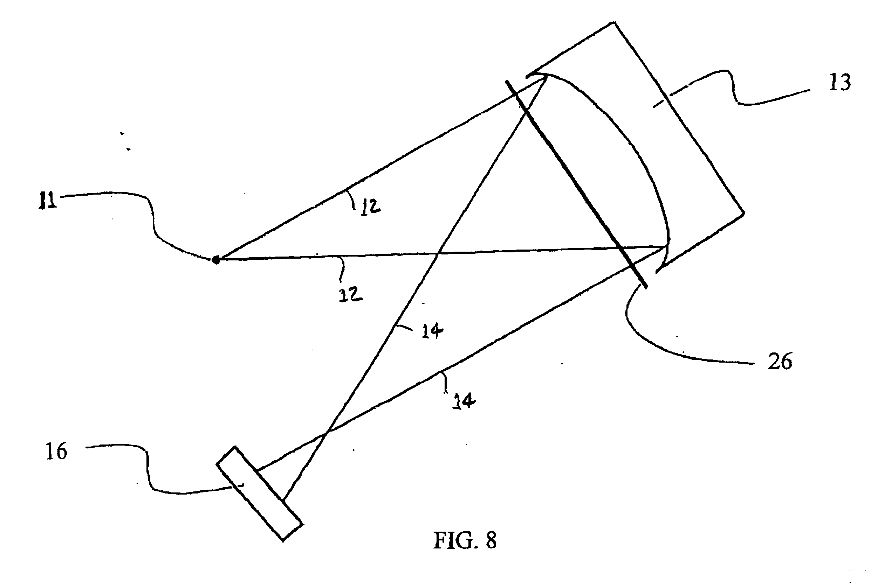

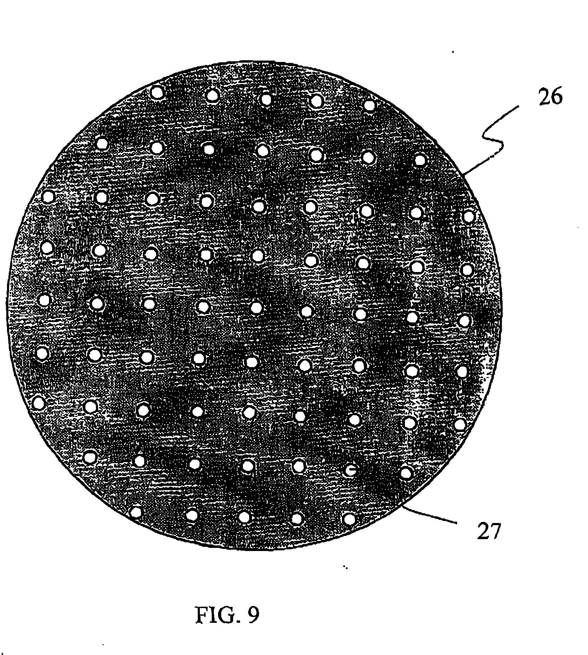

The Hartman Test method is depicted in FIG. 8, in which EUV light 12 from an EUV light source 11 is reflected by the multilayer mirror 13 to an image detector 16. Situated in front of the multilayer mirror 13 is a plate 26 defining an array of multiple apertures 27, as shown in FIG. 9. Hence, light incident to the image detector 16 is in the form of individual beamlets each corresponding to a respective aperture 27. The profile of the reflected wavefront from the multilayer mirror 13 is computed from the positional displacement of the beamlets. The EUV light source 11 can be, for example, a synchrotron-radiation light source, a laser-plasma light source, an electric-discharge-plasma light source, or an X-ray laser. The image detector 16 may be, for example, an imaging plate or a CCD responsive to EUV light.

A variation of the Hartman Test is the Shack-Hartmann Test. In the Shack-Hartman test as used for visible light, instead of the plate 26 defining an array of apertures 27 as used in the Hartman Test, a microlens array is used. The microlens array is situated at the pupil of the subject optical component. By using a zone plate instead of a microlens array, the Shack-Hartmann Test can be employed for measuring the profile of a reflected EUV wavefront.

Measurement of Transmitted Wavefront Profile

In some cases, if a lack of accuracy is experienced in the interference-measurement techniques such as those described above, at-wavelength measurements of the reflected wavefront from a multilayer mirror can be difficult to perform. In such an instance, a mockup of an EUV optical system can be configured using suitable optical elements and the multilayer mirror to be evaluated, and at-wavelength measurements of a wavefront transmitted by the optical system. At-wavelength measurements of a wavefront transmitted by an optical system are easier to perform than measuring the surface of a multilayer mirror. The reasons for this are as follows: Most surfaces in EUV optical systems are aspherical. Aspherical surfaces are more difficult to measure than spherical surfaces. However, even though one or more surfaces of the subject optical system are aspherical, a wavefront transmitted by the optical system will be spherical and therefore easier to measure. According to Equation (1), above, the tolerance for a wavefront aberration (WFE) of an optical system is larger than the tolerance for profile error (FE) of the multilayer mirror. Thus, it is easier to measure the wavefront than to measure the mirror surface. Optical-design software can be used to compute respective corrections to be applied to the reflective surface of the mirror from the results of the transmitted wavefront-profile measurements. Subsequent procedures are similar to corresponding procedures for measuring the profile of the reflective surface of a separate multilayer mirror. Exemplary techniques for measuring a transmitted wavefront profile are summarized below:

Shearing Interferometry

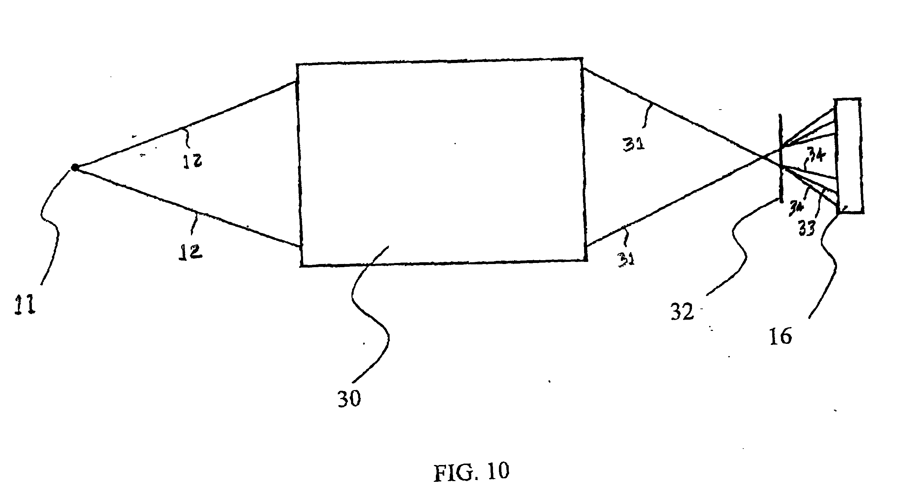

Use of shearing interferometry to measure a transmitted wavefront at wavelength is shown in FIG. 10. EUV light 12 from an EUV light source 11 is transmitted by the EUV optical system 30. The transmitted rays 31 are split up by passage through a transmission diffraction grating 32 and are incident to an image detector 16. On the image detector 16, zero-order rays 33 (propagating along a straight-line trajectory through the depicted system) and first-order rays 34 (propagating along respective trajectories altered from the straight-line trajectory by diffraction) are laterally shifted so as to overlap with each other. The resulting interference pattern is recorded. Since the interference pattern includes surface-slope data, the profile of the wavefront transmitted by the EUV optical system 30 is computed by performing mathematical integration of the slope data- The light source 11 may be, for example, a synchrotron-radiation light source, a laser-plasma light source, an electric-discharge-plasma light source, or an X-ray laser. The image detector 16 can be, for example, an imaging plate or a CCD sensitive to EUV radiation.

Point-Diffraction Interferometry

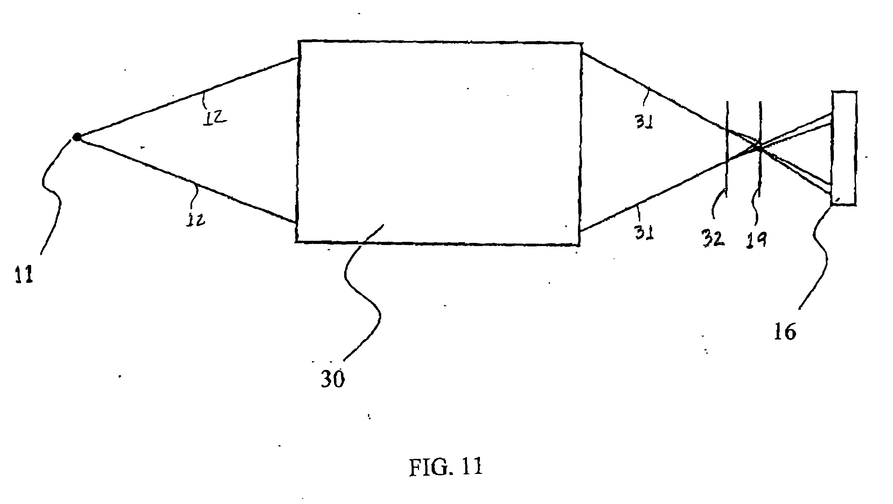

The point-diffraction interferometry (PDI) technique is shown in FIG. 11, in which rays 12 from a light source 11 are transmitted by an EUV optical system 30. The wavefront of the transmitted rays 31 is split up by passage through a transmission diffraction grating 32. A PDI plate 19 is situated at the point of convergence of the rays. As shown in FIG. 4, the PDI plate 19 defines a relatively large aperture 20 and a relatively small pinhole 21. The pitch of the diffraction grating 32 and the separation between the aperture 20 and the pinhole 21 are such that, of the diffraction orders of rays of the wavefront that are produced by the diffraction grating 32, the zero-order rays pass through the pinhole 21, and first-order diffracted rays pass through the aperture 20. The rays passing through the pinhole 21 are diffracted to form an aberration-less spherical wavefront, while rays passing through the aperture 20 include the aberrations of the EUV optical system 30. The interference pattern formed by these overlapping wavefronts is detected by the image detector 16. The profile of the wavefront transmitted by the EUV optical system 30 is computed from the interference pattern. Since the source 11 must provide EUV light capable of exhibiting a large amount of interference, only sources such as a synchrotron-radiation source or an X-ray laser may be used. The image detector 16 may be, for example, an imaging plate or a CCD responsive to EUV light.

Foucalt Test

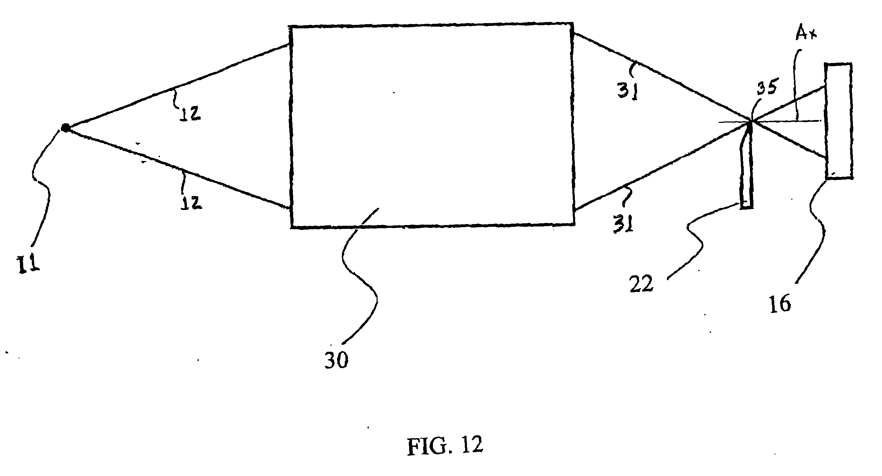

The Foucalt Test for obtaining at-wavelength measurements of a transmitted EUV wavefront is depicted in FIG. 12. Rays 12 of EUV light from a light source 11 are transmitted by the EUV optical system 30 and are incident on an image detector 16. A knife edge 22 is placed at the point of convergence 35 of the transmitted rays 31. The shape of the wavefront transmitted by the EUV optical system 30 is computed from changes occurring in the pattern received by the image detector 16 as the knife edge 22 is moved normal to the optical axis Ax. The light source 11 may be, for example, a synchrotron-radiation light source, a laser-plasma light source, an electric-discharge-plasma light source, or an X-ray laser. The image detector 16 can be an imaging plate or a CCD responsive to EUV radiation.

Ronchi Test

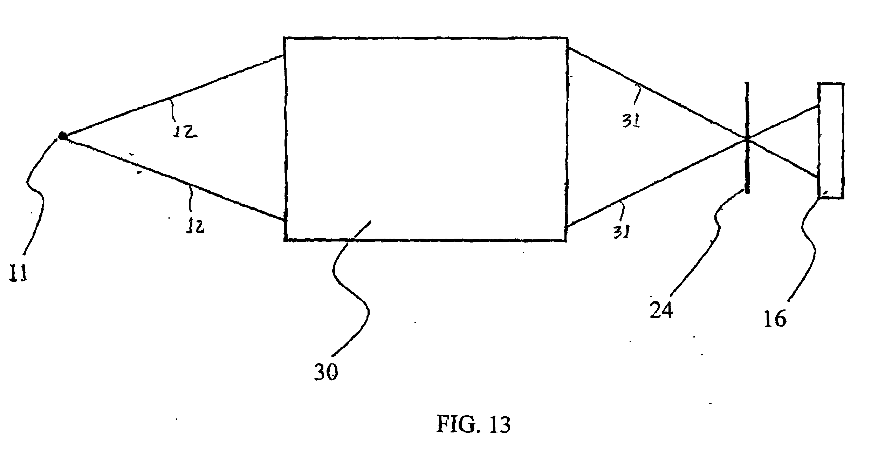

The Ronchi Test for obtaining at-wavelength measurements of a transmitted wavefront is shown in FIG. 13, in which rays 12 from a light source 11 are transmitted by the EUV optical system 30 and are incident on an image detector 16. A Ronchi grating 24 is situated at the point of convergence of the rays. As shown in FIG. 7, the Ronchi grating 24 is an opaque plate defining multiple oblong rectangular apertures 25. Since the line pattern formed on the image detector 16 is a function of aberrations in the optical system 30, the profile of the wavefront transmitted by the EUV optical system 20 is computed by analyzing the pattern. The light source 11 may be, for example, a synchrotron-radiation light source, a laser-plasma light source, an electric-discharge-plasma light source, or an X-ray laser. The image detector 16 may be, for example, an imaging plate or a CCD responsive to incident EUV radiation.

Hartmann Test

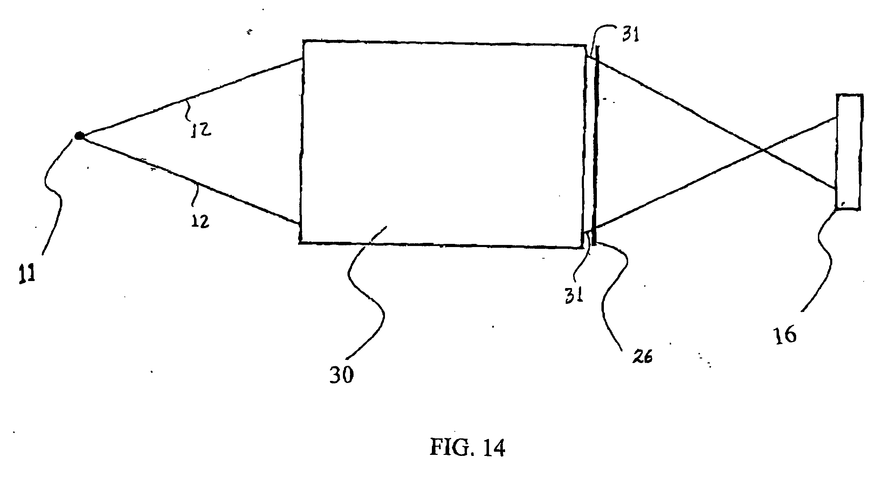

The Hartmann Test for obtaining at-wavelength measurements of a transmitted EUV wavefront is shown in FIG. 14, in which light 12 from a light source 11 is transmitted by the EUV optical system 30 and are incident on an image detector 16. Situated just downstream of the EUV optical system 30 is a plate 26 defining an array of apertures 27, as shown in FIG. 9. EUV light incident to the image detector 16 is in the form of beamlets each corresponding to a respective aperture 27. The wavefront profile of rays 31 transmitted by the EUV optical system 30 is computed from the positional displacement of the beamlets. The light source 11 may be, for example, a synchrotron-radiation light source, a laser-plasma light source, an electric-discharge-plasma light source, or an X-ray laser. The image detector 16 can be, for example, an imaging plate or a CCD responsive to incident EUV radiation.

A variation of the Hartman Test is the Shack-Hartmann Test. In the Shack-Hartman test as used for visible light, instead of a plate 26 defining an array of apertures 27 as used in the Hartman Test, a microlens array is used. The microlens array is situated at the pupil of the subject optical system. By using a zone plate instead of a microlens array, the Shack-Hartmann Test can be employed for measuring the profile of a transmitted EUV wavefront.

Although the various test methods described above were described in the context of Mo/Si multilayer films for use in EUV microlithography at a wavelength of 13.4 nm, these parameters are not in any way intended to be limiting. The methods can be applied with equal facility to other wavelength regions and other multilayer-film materials.

The results obtained using any of the test methods described above provide a contour profile of a subject multilayer mirror or EUV optical system including one or more such mirrors. Based on the contour profile, selected region(s) of a mirror are removed in a controlled manner that results in partial or complete removal of one or more surficial layers of the multilayer film. According to one aspect of the invention, the machining yields a smooth transition from the machined region to the non-machined region.

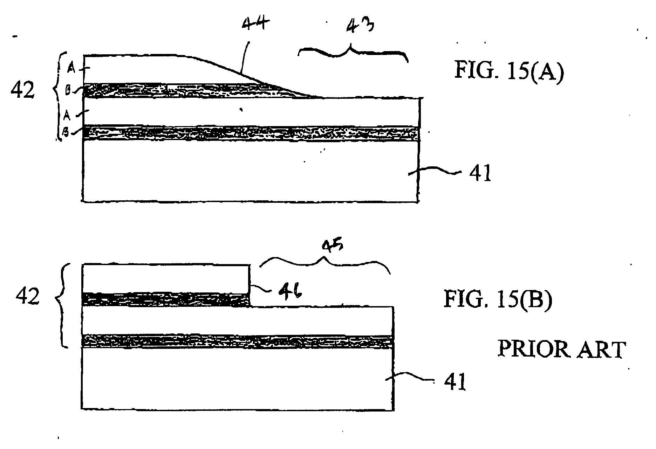

This smooth transition is shown in FIG. 15(A), depicting a gradual cross-sectional profile characterized by a lack of step topology. FIG. 15(A) shows a mirror substrate 41 on which an exemplary multilayer film 42 of the layers A and B has been formed. A region 43 has been machined, the edge of which has a sloped profile 44. (Compare FIG. 15(A) with the conventional machined region 45, shown in FIG. 15(B), having a stepped edge 46). Conventionally, as shown in FIG. 15(B), the step 46 arises at the boundaries of machined regions 45. Such step topology produces a jagged elevational section of the "corrected" reflection wavefront, as shown in FIG. 30(B). Machining according to one aspect of the invention, on the other hand, yields a smooth corrected-wavefront profile 47 as shown in FIG. 30(C), which produces no adverse effects such as diffraction. Comparing FIGS. 30(B) and 30(C), the RMS value for the wavefront error after corrective machining also can be minimized.

Small-tool Corrective Machining

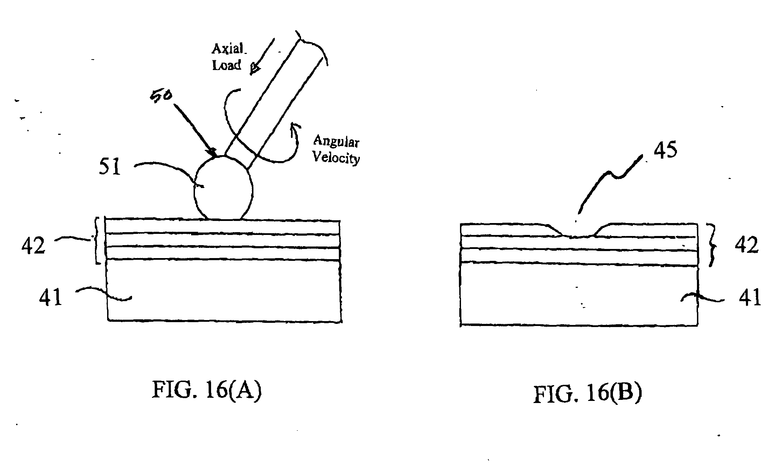

On the surface of a multilayer mirror or other reflective optical component, a smooth corrected-wavefront profile can be achieved using any of various "small-tool corrective-machining methods," including mechanical polishing, ion-beam machining, and chemical vapor machining (CVM). Use of a mechanical polisher is shown in FIGS. 16(A)-16(B). Referring first to FIG. 16(A), a polishing tool 50 having a relatively small diameter tip 51 (e.g., approximately 10 mm) is rotated about its axis while being urged against the surface of the multilayer film 42. Polishing proceeds as a polishing abrasive (not shown) is applied to the surface of the multilayer film 42 between the tip 51 of the tool 50 and the surface of the multilayer film 42. The speed at which machining proceeds is a product of factors such as: (a) the axial load applied to the polishing tool 50, (b) the angular velocity of the polishing tool 50 relative to movement velocity of the target material (in this case, the surface of the multilayer film 42), and (c) the residency time of the tip 51 of the polishing tool 50 on the surface of the multilayer film 42. In this method, it will be understood that the polishing force is less at the periphery than at the center of the tip 51 of the polishing tool 50; the resulting differential machining produces a smooth cross-sectional profile of the machined region 45, as indicated in FIG. 16(B).

Although FIGS. 16(A)-16(B) depict a polishing tool 50 having a spherical tip 51, such a tip shape is not intended to be limiting. As an alternative, the polishing tool 50 can have a disc-shaped tip, for example. With a disc-shaped polishing tool, the peripheral polishing force is less than at the center of the polishing tool, which also produces a smooth cross-sectional surface profile as shown in FIG. 16(B).

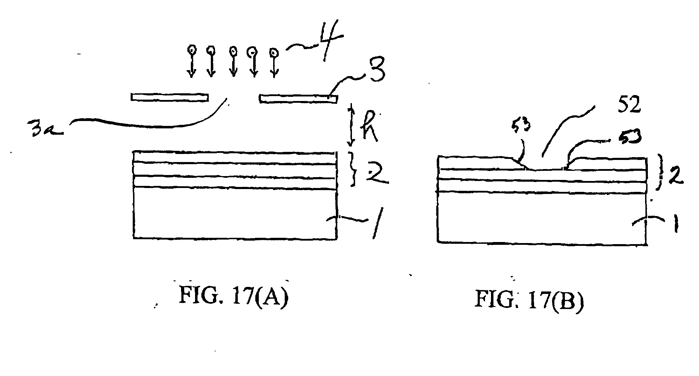

FIGS. 17(A)-17(B) depict ion-beam machining using a mask 3. Unlike the method shown in FIGS. 31(A)-31(B) in which the mask 3 is situated on the surface of the multilayer film 2, the mask 3 in FIG. 17(A) is displaced away from the surface of the multilayer film 2 by a distance h. The mask 3 can be a stainless steel plate defining openings 3a formed in the plate by etching or other suitable means. Ions 4 are directed at the mask 3 toward the surface of the multilayer film 2. Ions passing through the openings 3a impinge on and locally erode the surface of the multilayer film 2. For machining, the ions 4 can be of argon (Ar) or other inert gas. Alternatively, the ions 4 can be of any of various reactive ionic species, such as fluorine ions or chlorine ions. Depending upon the properties of the ion source employed, the ion beam usually is not collimated, but rather exhibits a scattering angle relative to the axis of ion-beam propagation. The resulting spatial distribution of the ion beam directed onto the surface of the multilayer film 2 yields a machined region 52 (FIG. 17(B)) typically wider than the corresponding aperture 3a and exhibiting tapered shoulders and a smooth elevational profile. The shoulder profile and width of the machined area 52 can be adjusted by changing the distance h; the greater the distance h of the mask 3 from the surface of the multilayer film 2, the broader the machined region 52 relative to the respective opening 3a.

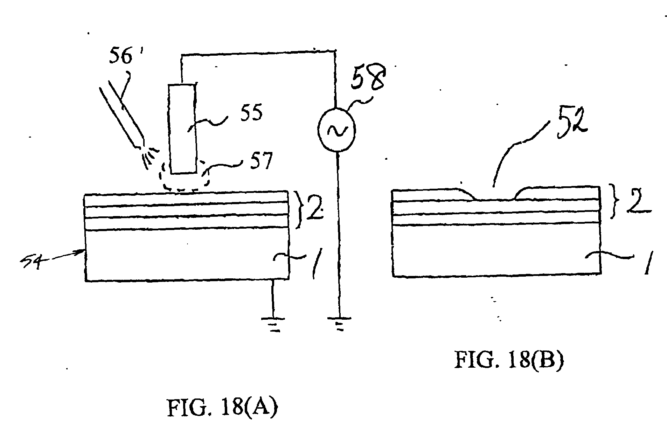

FIGS. 18(A)-18(B) depict chemical-vapor machining (CVM), during which the workpiece (mirror) 54 is electrically grounded as shown. Machining is performed by positioning an electrode 55 adjacent a desired region on the surface of the multilayer film 2 while applying a radio-frequency (RF) voltage 58 (at a frequency of approximately 100 MHz) to the electrode 55. Meanwhile, a reactive-gas mixture (of, e.g., helium (He) and sulfur hexafluoride ($SF_6$)) is discharged at the surface of the multilayer film 2 from a nozzle 56. Under such conditions between the electrode 55 and the surface of the multilayer film 2, a plasma 57 is generated. In this example, the plasma 57 includes fluorine ions that react with the surface of the multilayer film 2 and produce reaction products having a high vapor pressure. Thus, the surface of the multilayer film 2 adjacent the tip of the electrode 56 is eroded. Processing speed is a function of the density of the plasma 57, and hence is greatest directly beneath the electrode 55 and slower around the periphery of the electrode 55. The resulting differential machining rate yields a smooth elevational profile as indicated in FIG. 18(B).

Although the description above is set forth in the context of a Mo/Si multilayer film on a reflective multilayer mirror intended for use with a 13.4 nm wavelength characteristic of EUV microlithography, it will be understood that this is not intended to be limiting. The same principles discussed above can be applied with equal facility to multilayer films suitable for use with other wavelengths, and made of other film materials besides Mo and Si.

In any event, by reducing the incidence of discontinuous topology when performing surficial machining of one or more layers from the surface of a multilayer film, the optical properties of the multilayer mirror are not as prone to degradation (especially by diffraction) when correcting the wavefront profile of EUV light reflected from the surface of the mirror.

Selective Reactive-Ion Etching

Reactive-ion etching (RIE) also can be used to achieve a smooth corrected-wavefront profile from a multilayer mirror. In using this technique, different etching rates of different thin-film materials can be exploited in a useful way.

By way of example, consider a multilayer film comprising multiple layer pairs (each 6.8 nm thick) of Mo (each 2.4 run thick) and Si (each 4.4 nm thick). A corrected surface profile of approximately 0.2 nm can be achieved by removing a surficial layer pair from the multilayer film using RIE. The resulting correction is due principally to removal of the Mo layer. However, it is difficult to stop removal of a Mo layer at a desired thickness of the Mo layer.

To provide better control of removing a desired thickness of the Mo layer, the Mo layer is configured as a layer group comprising respective sub-layers of multiple substances, wherein the layer group has a total thickness of 2.4 nm. The different substances exhibit different respective rates of erosion by RIE. By configuring each Mo layer as a respective layer group, it is possible to control the depth of etching of the layer group by RIE by exploiting the differences in the RIE properties of the sublayers.

For example, with respect to EUV radiation, Ru (ruthenium) has an index of refraction that is sufficiently close to that of Mo to allow Ru to be used as a sublayer material along with at least one sublayer of Mo. In other words, at least one surficial Mo layer in the multilayer mirror is substituted with a respective Mo "layer group" having the same total thickness (e.g., 2.4 nm) as the original Mo layer. The layer group consists of at least one sublayer of Mo and at least one sublayer of Ru. The sublayers are formed in an alternating manner with respect to the materials. Since Ru has an index of refraction close to that of Mo in the EUV region, each layer group optically behaves as a respective layer consisting only of Mo, and thus has little effect on the reflective properties of the mirror.

When performing RIE of a layer group as described above, the RIE parameters can be configured to remove Mo preferentially to Ru, or configured to remove Ru preferentially to Mo. For example, a "Mo-sublayer-removal RIE" involving reactive chemical species that react preferentially with Mo compared to Ru can be used to remove a topmost Mo sublayer. Removal of the topmost Mo sublayer exposes the underlying Ru sublayer, which is relatively resistant to the prevailing RIE conditions. Consequently, RIE-mediated removal of material from the surface of the mirror stops at the Ru sublayer. Conversely, a "Ru-sublayer-removal RIE" involving reactive chemical species that react preferentially with Ru but compared to with Mo can be used to remove a topmost Ru layer. Removal of the topmost Ru sublayer exposes the underlying Mo sublayer, which is relatively resistant to the prevailing RIE conditions. Consequently, RIE-mediated removal of material from the surface of the mirror stops at the Mo sublayer.

The selective RIE technique described above allows Mo and Ru layers to be removed selectively from a topmost layer group, one sublayer at a time. The technique is not limited, however, to layer groups each comprising only two sublayers. Each layer group alternatively can comprise multiple sublayer pairs each including a sublayer of Mo and a sublayer of Ru. For example, a layer group can comprise three layer pairs of Mo and Ru sublayers that are alternatingly stacked in the layer group to yield a total thickness of, for example, 2.4 nm for the layer group. In this example, the thickness of each individual Mo and Ru sublayer is 0.4 nm.

Continuing further with this example, if the topmost sublayer in the topmost layer group is Mo, execution of Mo-sublayer-removal RIE followed by Ru-sublayer-removal RIE can be performed to individually remove the topmost Mo sublayer followed by the topmost Ru sublayer of the layer group. Thus, a total of 0.8 nm of surficial material is removed from the layer group, leaving two pairs of Mo and Ru sublayers remaining in the layer group. By removing 0.8 nm of surficial material, a correction of 0.067 nm is made to the surface profile. If only one sublayer had been removed, a 0.033 nm correction would have been made.

Generally, if a Mo layer group is constructed by alternatingly stacking Mo and Ru sublayers for a total of z sublayers (in place of the original Mo layer), the resulting layer group would have z/2 sublayer pairs, and the thickness of each sublayer would be (2.4 nm)/z. This would provide a correction per sublayer of (0.2 nm)/z in the surface profile. By way of another example, if z = 4 (two sublayer pairs), then the amount of correction would be 0.05 nm per sublayer. By way of yet another example, if z = 10 (five sublayer pairs), then the amount of correction would be 0.02 nm per sublayer.

RIE is performed using halide gases, such as chlorides and fluorides, or chlorine and oxygen gases. The gases are ionized and directed onto the target surface to cause etching of the target surface. Selected combinations of target materials can be etched depending upon the particular etching gas(es) used and the material properties of the target surface to be etched. Selective etching can be conducted by using appropriate reactive gases that react rapidly with specific target materials versus reactive gases that react only slowly or not at all with the specific target materials, thereby allowing complex and detailed surficial profiles to be created. To terminate and control the etching process, a layer that is not etched by a given gas is provided as a protection sublayer so that the etching does not proceed depthwise past the protection sublayer.

In the example described above involving a layer group comprising alternating sublayers of Mo and Ru, RIE parameters can be selected that favor etching of the Mo sublayer (wherein the underlying Ru sublayer acts as a protection layer) or that favor etching of the Ru sublayer (wherein the underlying Mo sublayer acts as a protection layer). Thus, the Mo and Ru sublayers in the layer group can be removed one sublayer at a time.

Thus, in a Mo/Si layer pair in a multilayer film of a multilayer mirror, a Mo layer is replaced with a layer group consisting of at least one Mo sublayer and at least one Ru layer. By combining RIE protocols that achieve selective removal of either a topmost Mo sublayer or a topmost Ru sublayer of the topmost layer group, a smaller depthwise increment of material can be removed from the multilayer film during surficial machining, compared to the conventional 0.2-nm or greater increment that is removed using conventional methods.

Optimizing Reflectivity

As noted above, the change $\Delta$ in optical path

length due to removing a layer from a multilayer film (comprised of alternating layers of substance A and substance B) can be found from the equation:

$$\Delta = nd - (n_A d_A + n_B d_B)$$

wherein n denotes the refractive index of a vacuum, $n_A$ denotes the refractive index of substance A, $n_B$ denotes the refractive index of substance B, d is the period length of the multilayer film, $d_A$ denotes the thickness of a layer of substance A, and $d_B$ denotes the thickness of a layer of substance B.

To obtain high reflectivity, multilayer films generally are composed of multiple layers of a substance (e.g., Mo, Ru, or Be) having a refractive index that differs substantially from the refractive index of a vacuum and of a substance (e.g., Si) having a refractive index that differs very little from the refractive index of a vacuum. In this discussion, substance "A" is designated as having a refractive index that differs substantially from that of a vacuum, and substance "B" is designated as having a refractive index that differs very little from the refractive index of a vacuum. Let $\Gamma$ denote the ratio of the thickness of a layer of substance A to the period length (d) of the multilayer film. During local machining of a multifilm mirror performed to achieve a corrected wavefront of EUV light from the mirror, a change in optical path length of the multilayer film occurs principally whenever a layer of substance A is removed. Removing a layer of substance B produces little change in optical path length. Therefore, the change, $\Delta$, in optical path length due to the removal of one layer from the multilayer film can be minimized by reducing the value of $\Gamma$ while holding d constant..

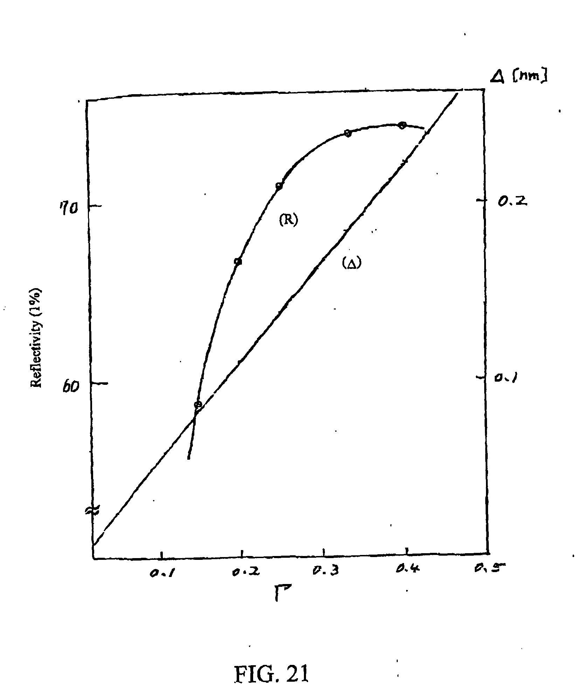

However, changing $\Gamma$ changes the reflectivity of the multilayer film to EUV light. Nevertheless, there is a value of $\Gamma$ (denoted $\Gamma_m$) corresponding to maximum reflectivity. Reducing $\Gamma$ from $\Gamma_m$ is accompanied by a rapid reduction in reflectivity. This relationship is depicted in FIG. 21, in which the plotted data were obtained from calculations of reflectivity (R; in %) of a Mo/Si multilayer film (d = 6.8 nm; number of stacked layers = 50 layer pairs) to 13.4-nm EUV light directly incident on the film incidence. The abscissa is of values of $\Gamma$, the left-hand ordinate is of reflectivity, and the right-hand ordinate is of values of $\Delta$. The linear plot is of data in the right-hand ordinate, and the curved plot is of data in the left-hand ordinate. From FIG. 21 it can be seen that reducing $\Gamma$ to minimize $\Delta$ per layer pair removed from the multilayer film produces a rapid decrease in reflectivity.

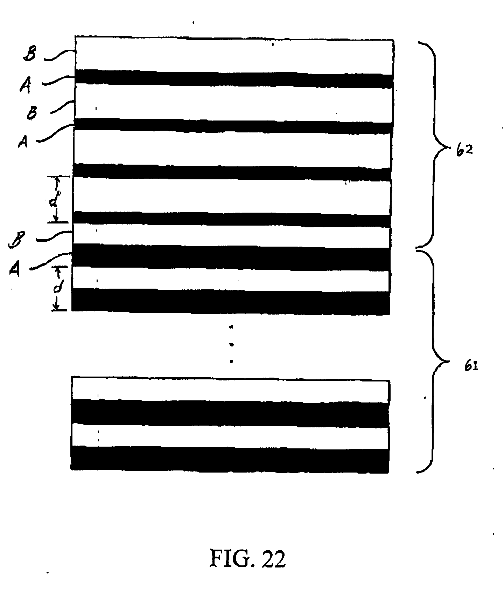

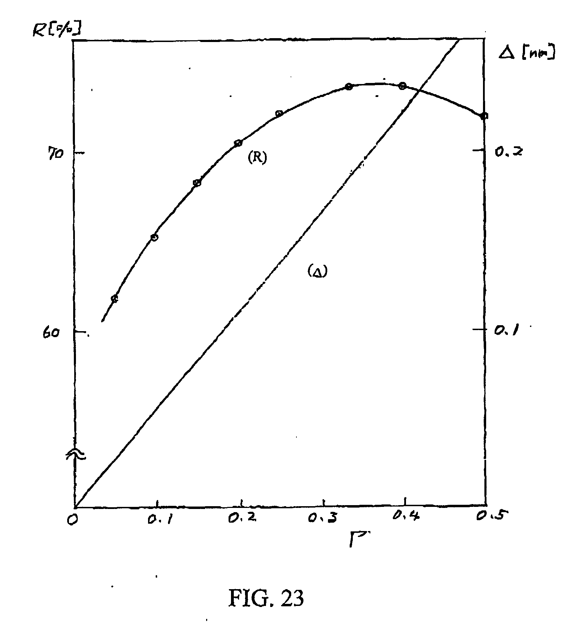

By way of example, and referring to FIG. 22, a first multilayer film 61 (comprising alternating layers of substances A and B) was deposited of which the value of $\Gamma$ (i.e., $\Gamma_1$) corresponded to maximal reflectivity. A second multilayer film 62 (comprising alternating layers of substances A and B) was subsequently deposited superposedly on the first multilayer film 61. The second multilayer film 62 had a value of $\Gamma$ (i.e, $\Gamma_2$), wherein $\Gamma_2 < \Gamma_1$, configured so as to achieve a desired change in $\Delta$. In this example, $\Gamma_1 = 1/3$, d = 6.8 nm, and the number of stacked layer pairs (N) is $N_1 = 40$. FIG. 23 is a plot of the results of calculating reflectivity R of the Mo/Si multilayer film to 13.4-nm EUV light directly incident to the multilayer film. In FIG. 23 the abscissa is of values of $\Gamma_2$, ranging from $\Gamma_2 = 0$ to 0.5; the; the left-hand ordinate is of reflectivity (R, in %); and the right-hand ordinate is of the change $\Delta$ in optical path length. By comparing FIG. 23 with FIG. 21, it can be seen that a reduction in $\Gamma$ over a fairly broad range results in relatively small decreases in reflectivity. Thus, the change $\Delta$ in optical path length accompanying removal of each layer from the multilayer film can be minimized without significantly sacrificing the reflectivity R of the multilayer film.

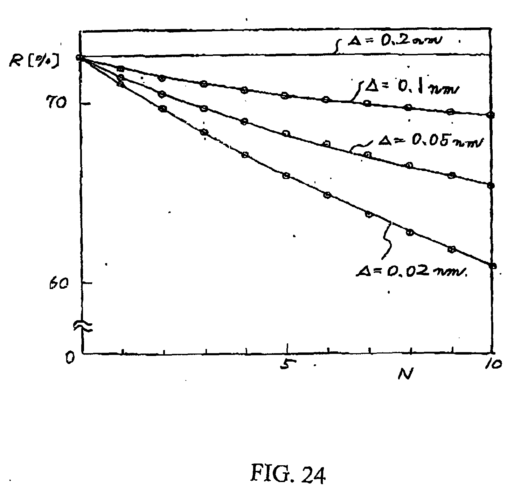

The first multilayer film 61 desirably is optimized to obtain the maximum reflectivity R. The second multilayer film 62, formed superposedly on the first multilayer film 61, desirably is configured so as to obtain the desired change $\Delta$ in optical path length. As surficial portions of the second multilayer film 62 are removed one layer at a time, the overall reflectivity of the mirror increases, as illustrated in FIG. 24. The data plotted in FIG. 24 were obtained by calculating the reflectivity R of a Mo/Si multilayer film to which 13.4-nm EUV light was directly incident. The multilayer comprised a second multilayer film 62, in which d = 6.8 nm, $\Gamma_2 \neq \Gamma_1$, and $N_2 = 10$, stacked on a first multilayer film 61, in which d = 6.8 nm, $\Gamma_1 = 1/3$, and $N_1 = 40$. The plots correspond to different respective changes $\Delta$ in optical path length of 0.2 nm, $\Delta = 0.1$ nm, $\Delta = 0.05$ nm, and $\Delta = 0.02$ nm, according to differences in $\Gamma$. As layers are removed layer-by-layer from the second multilayer film (i.e., $N_2$ incrementally decreases from 10), the overall reflectivity of the mirror increases. For example, upon forming the second multilayer film 62 with $\Delta = 0.05$ nm and $N_2 = 10$, the reflectivity R before removing any layer is 65.2%. Removing five layer pairs causes R to increase to 68.2%, and removing ten layer pairs causes R to increase to 72.5%. Thus, the smaller the change $\Delta$ in optical path length upon removing each layer pair from the surface of the multilayer film and the greater the number of layers removed, the greater the change in reflectivity.

These changes in reflectivity of the multilayer mirror can create on-surface reflectivity irregularities after correcting the reflection wavefront profile. However, from the allowable on-surface reflectivity irregularities, optimal changes $\Delta$ in optical path length and the number of layers to be removed can be determined.

In situations in which the tolerance for on-surface reflectivity irregularities is stringent, a substance having a refractive index that differs only a small amount from the refractive index of a vacuum can be formed on the surface of the mirror after corrective machining has been performed (see below) to provide a correction ensuring uniform reflectivity. For example, at $\lambda = 13.4$ nm, the refractive index of silicon is 0.998, which is virtually equal to 1. Hence, forming a surficial silicon layer causes little change in optical path length of the multilayer film of the mirror.

The absorption coefficient ("a") of silicon is a = $1.4 \times 10^{-3}$ $((nm)^{-1})$. Upon propagating a distance x, the intensity of light diminishes by exp(-ax). For example, by forming a surficial layer of silicon that is 37 nm thick, reflectivity could be reduced by 10%. However, the resulting change $\Delta$ in optical path length resulting from forming the surficial silicon layer is 0.07 nm, which is acceptably small.

Although this embodiment was described in the context of a Mo/Si multilayer film as used with a 13.4 nm EUV wavelength, it will be understood that this is not intended to be limiting. Alternatively to the configuration discussed above other wavelength regions and other multilayer-film materials can be used. In addition, it is not necessary that the materials A, B making up the first multilayer film 61 and the second multilayer film 62 be the same.

Protective Layer to Reduce Reflectivity Variations

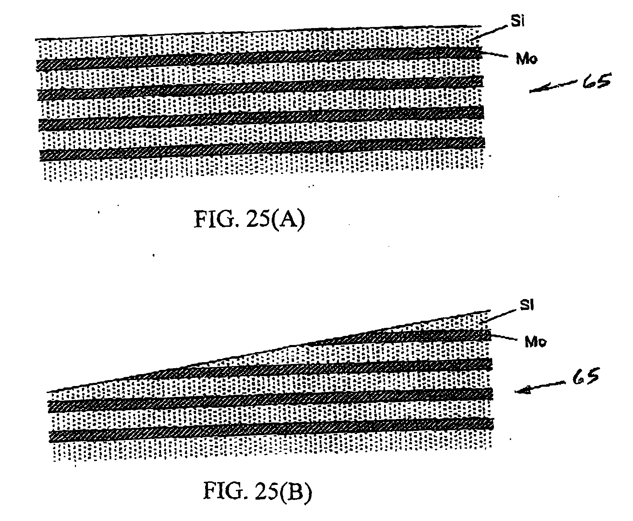

FIG. 25(A) depicts a transverse elevational section of a multilayer film 65 as formed on an EUV-reflective mirror, according to this embodiment. By way of example, the depicted multilayer film 65 is of stacked alternating layers of Mo and Si (e.g., N = 80 layer pairs) with a period length of d = 7 nm and ratio ($\Gamma$) of Mo-layer thickness to d of $\Gamma$ = 0.35. The stacked layers are formed on a mirror substrate (not shown, but see FIGS. 15(A)-15(B)). After forming the multilayer film 65, a region of the surface of the film is machined away, using any of the techniques described above (e.g., ion-beam machining), to achieve correction of the reflected EUV wavefront from the surface. The resulting profile is as shown in FIG. 25(B).

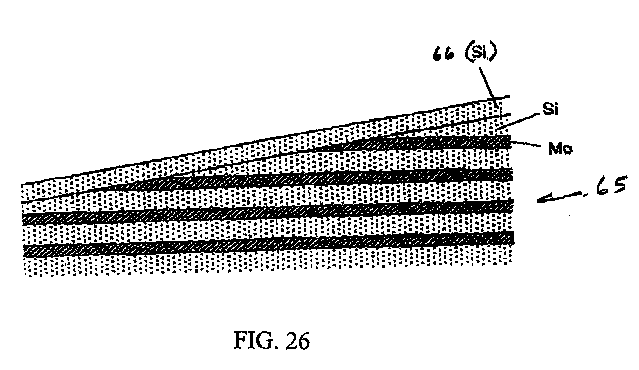

After machining, the exposed surface of the multilayer film 65 is "coated" with a cover layer 66 of Si formed at a thickness of 2 nm, as shown in FIG. 26. In the mirror of FIG. 26, the period length (d) in a machined region on the surface of the multilayer film 65 varies with position on the machined surface.

As discussed above, the reflectivity of EUV radiation from a Si/Mo multilayer mirror is at a saturated maximum at about N = 50 layer pairs. However, because surficial machining potentially can remove more than ten surface layers, a larger number such as 80 layers desirably are formed. Also, because the amount of surficial material removed by the machining step exhibits a continual change with position on.the surface, the machined surface (whether of Mo or Si) has any of various profiles to which incident rays have a corresponding angle of incidence.

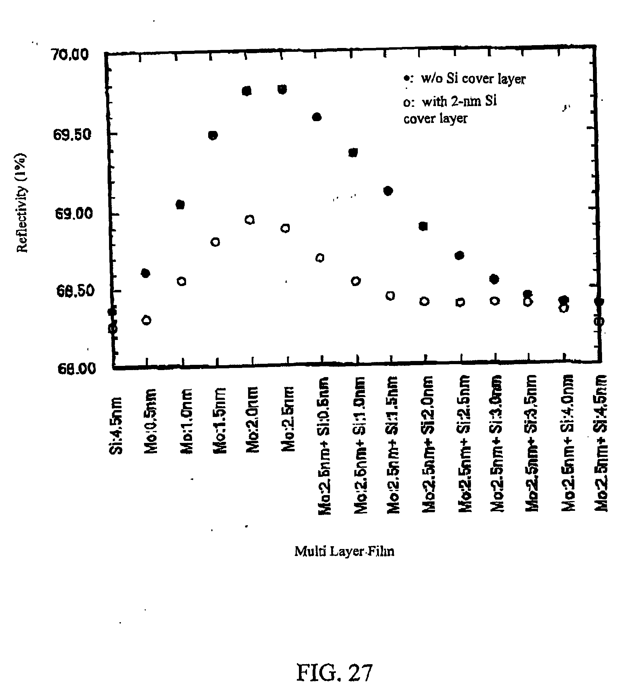

The surficial Si cover layer 66 achieves a uniform reflectivity of the multilayer film 65 after machining. To-illustrate this effect, reference is made to FIG. 27, which shows, by way of example, reflectivity (o) from a surface including a 2-nm thick Si cover layer and reflectivity (•) from a surface lacking the Si cover layer. The subject mirror has a multilayer film comprising alternating layers of Mo and Si, and the incident EUV radiation (non-polarized) has $\lambda$ = 13.5 nm and an angle of incidence of 88 degrees. The abscissa lists representative conditions of the topmost layer of the multilayer film on which machining was performed.

In regions in which Mo is exposed by machining, the reflectivity gradually increases with increases in the thickness of the topmost Mo layer. In this particular multilayer film, the maximal Mo-layer thickness is 2.45 nm. Hence, the maximal thickness of the topmost Mo layer is 2.45 nm. In regions in which Si is exposed by machining, the reflectivity decreases somewhat with increases in the thickness of the Si layer. At 4.55 nm, the maximal Si-layer thickness in the multilayer film, the reflectivity is equal to the original reflectivity.

In this example, the magnitude of in-surface reflectivity change is approximately 1.5%. In contrast, if a 2-nm Si cover layer 66 is formed on the surface after machining, whereas the reflectivity decreases substantially at locations where Mo was exposed at the topmost layer, the reflectivity does not decline substantially in regions where Si was exposed by machining. Hence, the magnitude of the in-surface change in reflectivity is reduced to 0.7%, which is half the change experienced with no Si cover layer 66.

In addition to the reduced change in reflectivity, the Si cover layer (especially over exposed Mo) prevents oxidation of the exposed Mo. Thus, this embodiment (which includes the Si cover layer) provides a high-precision reflection wavefront while reducing variations in reflectivity over the surface of the mirror.

The material used to form the cover layer is not limited to Si. Alternatively, the cover layer can be of various substances capable of reducing variations in reflectivity of the mirror. Hence, as a result of the presence of the cover layer, the absolute value of the reflectivity of the mirror is not reduced.

Although this embodiment is described using an example in which the multilayer mirror comprises alternating layers of Mo and Si, this is not intended to be limiting. Any of various other materials could be used, taking into account the wavelength of the intended reflected radiation from the mirror, the required thermal stability of the mirror, and other properties or prevailing conditions. In addition, individual layers are not limited to single elements; rather, any layer can be a compound of multiple elements or a mixture of multiple elements or compounds.

Although this embodiment is described in the context of a multilayer film containing 80 stacked layer pairs, this is not intended to be limiting. A multilayer film mirror can have any of various numbers of layer pairs, depending upon the specifications the mirror is intended to meet, the prevailing conditions, characteristics of the radiation to be reflected from the mirror, and other factors.

Although this embodiment is described in the context of $\Gamma = 0.35$ (wherein $\Gamma$ is the ratio of the thickness of the Mo layer to d, the period length of the multilayer film), this is not intended to be limiting. This ratio can be any of various other values and need not be constant throughout the full thickness of the multilayer film or over the entire surface area of the multilayer film.

EUV Optical System

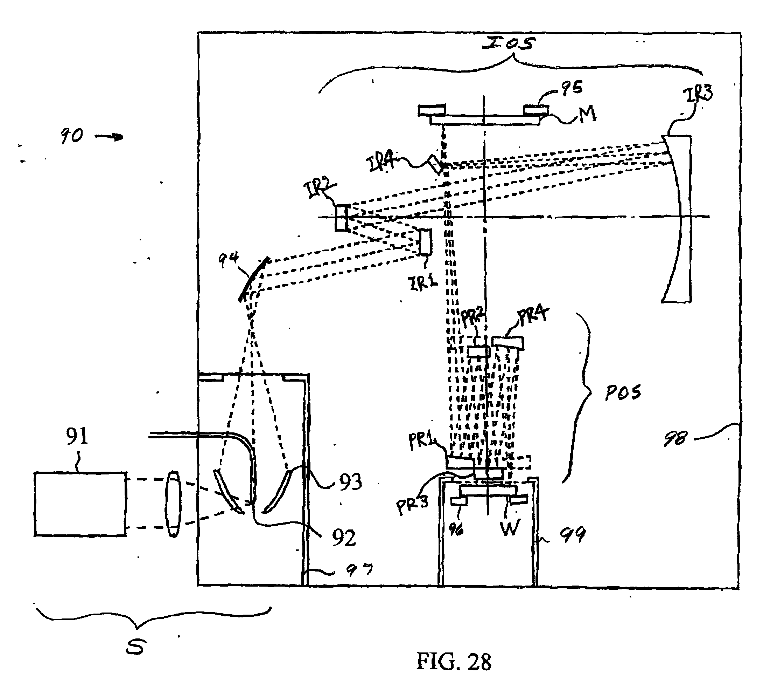

A representative embodiment of an EUV optical system 90 that includes one or more multilayer mirrors configured or produced as described above is shown in FIG. 28. The depicted EUV optical system 90 comprises an illumination-optical system IOS (comprising multilayer mirrors IR1-IR4) and a projection-optical system POS (comprising multilayer mirrors PR1-PR4), arranged in an exemplary configuration for use in EUV microlithography. Upstream of the illumination-optical system IOS is an EUV source S that, in the depicted embodiment, is a laser-plasma source including a laser 91, a source 92 of plasma-forming material, and a condenser mirror 93. The illumination-optical system IOS is situated between the EUV source S and a reticle M. EUV light from the source S reflects from a grazing-incidence mirror 94 before propagating to the first multilayer mirror IR1. The reticle M is a reflective reticle and typically is mounted on a reticle stage 95. The projection-optical system POS is situated between the reticle M and a substrate W (typically a semiconductor wafer having an upstream-facing surface coated with an EUV-sensitive resist). The substrate W typically is mounted on a substrate stage 96. The EUV source S (especially the plasma-material source 92 and condenser lens 93) is located in a separate vacuum chamber 97, which is situated in a larger vacuum chamber 98. The substrate stage 96 can be situated in a vacuum chamber 99 also situated in the larger chamber 98.

Working Example 1

In this working example a subject EUV projection-optical system (as used in an EUV microlithography apparatus) comprised six aspherical multilayer mirrors. The projection-optical system had a numerical aperture (NA) of 0.25, a demagnification ratio of 4:1, and a ringfield exposure area. The aspherical multilayer mirrors were fabricated, using conventional surface-polishing process technology, to a profile accuracy of 0.5 nm RMS. The multilayer mirrors were assembled into the projection-optical system, which exhibited a wavefront aberration of 2.4 nm RMS. For satisfactory use at a wavelength of 13.4 nm, the wavefront aberration must be about 1 nm RMS or less. Hence, the profile accuracy of the mirrors was not acceptable.

To produce each multilayer mirror, a Mo/Si multilayer film was formed on the surface of an aspherical mirror substrate. First, a 50-layer multilayer film, in which d = ion-beam sputtering formed 6.8 nm. On each multilayer mirror thus formed, areas of the surface of the multilayer film to be machined were identified by analyzing the reflection wavefront produced by the mirror. As required for each multilayer mirror, the respective surfaces were corrected by locally removing one or more layers from the surface of the respective multilayer film, one layer pair at a time, using the small-tool corrective polishing method depicted in FIGS. 16(A)-16(B), Removal of a pair of layers from the multilayer film 42 changed the optical path length by 0.2 nm. For machining, the tip 51 of the polishing tool 50 comprised a polyurethane sphere 10 mm in diameter. During polishing, a liquid slurry of finely particulate zirconium oxide was used as an abrasive. The amount of machining applied to the surface of the multilayer film 42 was controlled by adjusting the axial load applied to the polishing tool 50, the rotational velocity of the polishing tool 50, and the residency time of the polishing tool 50 on the surface of the multilayer film 42. The localized machining corrected each surface to a profile error of no greater than 0.15 nm RMS.

The corrected multilayer mirrors were assembled in a lens barrel and aligned with each other in a manner to minimize wavefront aberrations of the resulting projection-optical system. The obtained wavefront aberration of the system was 0.8 nm RMS, which was deemed sufficient for diffraction-limit imaging performance.

The projection-optical system thus fabricated was assembled in an EUV microlithography system, which was used for making test lithographic exposures. With the microlithography system, images of fine lineand-space patterns (having line and space widths as narrow as 30 nm) were resolved successfully.

Working Example 2

In this working example a subject EUV projection-optical system (as used in an EUV microlithography apparatus) comprised six aspherical multilayer mirrors. The projection-optical system had a numerical aperture (NA) of 0.25, a demagnification ratio of 4:1, and a ringfield exposure area. The aspherical multilayer mirrors were fabricated, using conventional surface-polishing process technology, to a profile accuracy of 0.5 nm RMS. The multilayer mirrors were assembled into the projection-optical system, which exhibited a wavefront aberration of 2.4 nm RMS. For satisfactory use at a wavelength of 13.4 nm, the wavefront aberration must be about 1 nm RMS or less. Hence, the profile accuracy of the mirrors was not acceptable.

During fabrication of each multilayer mirror, areas of the surface of the respective multilayer film to be machined were identified by analyzing the reflection wavefront produced by the mirror. As required for each multilayer mirror, the respective surface was corrected by locally removing one or more layers from the surface of the multilayer film, one layer pair at a time, using the ion-beam machining method depicted in FIGS. 17(A)-17(B). Removal of each pair of layers from the multilayer film 2 changed the optical path length by 0.2 nm. The machining was conducted in a vacuum chamber using argon (Ar) ions produced from a Kaufman-type ion source. Because the extent of achieved ion-beam machining varies with time, local machining rates on the multilayer film were measured in advance, and the extent of machining at a given location was controlled by controlling the machining time at that location. The mask 3 was a stainless plate in which openings were formed by etching. The distance h of the mask 3 from the surface of the multilayer film 2 was optimized experimentally beforehand to achieve a smooth elevational profile of machined regions 52 of the multilayer film. The localized machining corrected each surface to a profile error of no greater than 0.15 nm RMS.

The corrected multilayer mirrors were assembled in a lens barrel and aligned with each other in a manner to minimize wavefront aberrations of the resulting projection-optical system. The obtained wavefront aberration of the system was 0.8 nm RMS, which was deemed sufficient for diffraction-limit imaging performance.

The projection-optical system thus fabricated was assembled in an EUV microlithography system, which was used for making test lithographic exposures. With the microlithography system, images of fine line-and-space patterns (having line and space widths as narrow as 30 nm) were resolved successfully.

Working Example 3

In this working example a subject EUV projection-optical system (as used in an EUV microlithography apparatus) comprised six aspherical multilayer mirrors. The projection-optical system had a numerical aperture (NA) of 0.25, a demagnification ratio of 4:1, and a ring-field exposure area. The aspherical multilayer mirrors were fabricated, using conventional surface-polishing process technology, to a profile accuracy of 0.5 nm RMS. The multilayer mirrors were assembled into the projection-optical system, which exhibited a wavefront aberration of 2.4 nm RMS. For satisfactory use at a wavelength of 13.4 nm, the wavefront aberration must be about 1 nm RMS or less. Hence, the profile accuracy of the mirrors was not acceptable.

During production of each mirror, areas of the surface of the respective multilayer film to be machined were identified by analyzing the reflection wavefront produced by the mirror. As required for each multilayer mirror, the respective surfaces were corrected by locally removing one or more layers from the surface of the multilayer film, one layer pair at a time, using the CVM method depicted in FIGS. 18(A)-18(B). Removal of each pair of layers from the multilayer film 2 changed the optical path length by 0.2 nm. The machining was conducted in a vacuum chamber using a tungsten electrode 55 having a diameter of 5 mm. An RF voltage 58 (100 MHz) was applied to the electrode 55 as a mixture of helium and $SF_6$ was supplied to the region between the tip of the electrode 55 and the surface of the multilayer film 2. The gas mixture, ionized by the RF voltage 58 produced a plasma 57 containing fluorine ions and fluorine radicals that locally reacted with the silicon and molybdenum at the surface the multilayer film 2 and produced gaseous reaction products at room temperature. The reaction products were evacuated continuously during machining using a vacuum pump. Because the extent of achieved CVM is proportional to machining time, local machining rates on the multilayer film 2 were measured in advance, and the extent of machining at a given location was controlled by controlling the machining time at that location. The localized machining corrected each surface to a profile error of no greater than 0.15 nm RMS.

The corrected multilayer mirrors were assembled in a lens barrel and aligned with each other in a manner to minimize wavefront aberrations of the resulting projection-optical system. The obtained wavefront aberration of the system was 0.8 nm RMS, which was deemed sufficient for diffraction-limit imaging performance.

The projection-optical system thus fabricated was assembled in an EUV microlithography system, which was used for making test lithographic exposures. With the microlithography system, images of fine line-and-space patterns (having line and space widths as narrow as 30 nm) were resolved successfully.

Working Example 4

In this working example a subject EUV projection-optical system (as used in an EUV microlithography apparatus) comprised six aspherical multilayer mirrors. The projection-optical system had a numerical aperture (NA) of 0.25, a demagnification ratio of 4:1, and a ring-field exposure area. The aspherical multilayer mirrors were fabricated, using conventional surface-polishing process technology, to a profile accuracy of 0.5 nm RMS. The multilayer mirrors were assembled into the projection-optical system, which exhibited a wavefront aberration of 2.4 nm RMS. For satisfactory use at a wavelength of 13.4 nm, the wavefront aberration must be about 1 nm RMS or less. Hence, the profile accuracy of the mirrors was not acceptable.

To produce each multilayer mirror, a Mo/Si multilayer film was formed on the surface of an aspherical mirror substrate. First, a 50-layer multilayer film, in which d = 6.8 nm, was formed by ion-beam sputtering. Next, the wavelength profile of the reflective surface of each multilayer mirror was measured, at $\lambda$ = 13.4 nm, using shearing interferometry as shown in FIG. 2. For the light source 11, a laser-plasma light source was used. Based on the results of these measurements, a respective contour line plot (e.g., as shown in FIG. 1(A)) was generated for each multilayer mirror. The contour-line interval was set at 0.2 nm of surface height, which is equal to the correction of the profile of the reflective surface obtained by removing one layer-pair of the multilayer film. Based on their respective contour-line plots, selected regions of the surface of the multilayer films were removed layer-by-layer as required to correct the reflective surfaces. After correcting the multilayer mirrors, the wavefront aberration of each had been reduced to 0.15 nm RMS or less.

The corrected multilayer mirrors were assembled in a lens barrel and aligned with each other in a manner to minimize wavefront aberrations of the resulting projection-optical system. The obtained wavefront aberration of the system was 0.8 nm RMS, which was deemed sufficient for diffraction-limit imaging performance.

The projection-optical system thus fabricated was assembled in an EUV microlithography system, which was used for making test lithographic exposures. With the microlithography system, images of fine line-and-space patterns (having line and space widths as narrow as 30 nm) were resolved successfully.

Working Example 5

In this working example a subject EUV projection-optical system (as used in an EUV microlithography apparatus) comprised six aspherical multilayer mirrors. The projection-optical system had a numerical aperture (NA) of 0.25, a demagnification ratio of 4:1, and a ring-field exposure area. The aspherical multilayer mirrors were fabricated, using conventional surface-polishing process technology, to a profile accuracy of 0.5 nm RMS. The mirrors were assembled into the projection-optical system, which exhibited a wavefront aberration of 2.4 nm RMS. For satisfactory use at a wavelength of 13.4 nm, the wavefront aberration must be about 1 nm RMS or less. Hence, the profile accuracy of the mirrors was not acceptable.

To produce each multilayer mirror, a Mo/Si multilayer film was formed on the surface of an aspherical mirror substrate. First, a 50-layer multilayer film, in which d = 6.8 nm, was formed by ion-beam sputtering. Next, the wavefront profile of the reflective surface of each multilayer mirror was measured, at $\lambda$ = 13.4 nm, using point-diffraction interferometry as shown in FIG. 3. For the light source 11, an undulator (a type of synchrotron-radiation light source) was used. Based on the results of these measurements, a respective contour line plot was generated for each multilayer mirror. The contour-line interval was set at 0.2 nm of surface height, which is equal to the correction of the profile of the reflective surface obtained by removing one layer-pair of the multilayer film. Based on their respective contour-line plots, selected regions of the surface of the multilayer films were removed layer-by-layer as required to correct the reflective surfaces. After correcting the multilayer mirrors, the wavefront aberration of each had been reduced to 0.15 nm RMS or less.

The corrected multilayer mirrors were assembled in a lens barrel and aligned with each other in a manner to minimize wavefront aberrations of the resulting projection-optical system. The obtained wavefront aberration of the system was 0.8 nm RMS, which was deemed sufficient for diffraction-limit imaging performance.

The projection-optical system thus fabricated was assembled in an EUV microlithography system, which was used for making test lithographic exposures. With the microlithography system, images of fine line-and-space patterns (having line and space widths as narrow as 30 nm) were resolved successfully.

Working Example 6

In this working example a subject EUV projection-optical system (as used in an EUV microlithography apparatus) comprised six aspherical multilayer mirrors. The projection-optical system had a numerical aperture (NA) of 0.25, a demagnification ratio of 4:1, and a ring-field exposure area. The aspherical multilayer mirrors were fabricated, using conventional surface-polishing process technology, to a profile accuracy of 0.5 nm RMS. The mirrors were assembled into the projection-optical system, which exhibited a wavefront aberration of 2.4 nm RMS. For satisfactory use at a wavelength of 13.4 nm, the wavefront aberration must be about 1 nm RMS or less. Hence, the profile accuracy of the mirrors was not acceptable.

To produce each multilayer mirror, a Mo/Si multilayer film was formed on the surface of an aspherical substrate. First, a 50-layer multilayer film, in which d = 6.8 nm, was formed by ion-beam sputtering. Next, the wavefront profile of the reflective surface of each multilayer mirror was measured, at $\lambda$ = 13.4 nm, using the Foucalt Test method as shown in FIG. 5. For the light source 11, an electric-discharge-plasma source was used. Based on the results of these measurements, a respective contour line plot was generated for each multilayer mirror. The contour-line interval was set at 0.2 nm of surface height, which is equal to the correction of the profile of the reflective surface obtained by removing one layer-pair of the multilayer film. Based on their respective contour-line plots, selected regions of the surface of the multilayer films were removed layer-by-layer as required to correct the reflective surfaces. After correcting the multilayer mirrors, the wavefront aberration of each had been reduced to 0.15 nm RMS or less.

The corrected multilayer mirrors were assembled in a lens barrel and aligned with each other in a manner to minimize wavefront aberrations of the resulting projection-optical system. The obtained wavefront aberration of the system was 0.8 nm RMS, which was deemed sufficient for diffraction-limit imaging performance.

The projection-optical system thus fabricated was assembled in an EUV microlithography system, which was used for making test lithographic exposures. With the microlithography system, images of fine line-and-space patterns (having line and space widths as narrow as 30 nm) were resolved successfully.

Working Example 7

In this working example a subject EUV projection-optical system (as used in an EUV microlithography apparatus) comprised six aspherical multilayer mirrors. The projection-optical system had a numerical aperture (NA) of 0.25, a demagnification ratio of 4:1, and a ring-field exposure area. The aspherical multilayer mirrors were fabricated, using conventional surface-polishing process technology, to a profile accuracy of 0.5 nm RMS. The mirrors were assembled into the projection-optical system, which exhibited a wavefront aberration of 2.4 nm RMS. For satisfactory use at a wavelength of 13.4 nm, the wavefront aberration must be about 1 nm RMS or less. Hence, the profile accuracy of the mirrors was not acceptable.

To produce each multilayer mirror, a Mo/Si multilayer film was formed on the surface of an aspherical mirror substrate. First, a 50-layer multilayer film, in which d = 6.8 nm, was formed by ion-beam sputtering. Next, the wavefront profile of the reflective surface of each multilayer mirror was measured, at $\lambda$ = 13.4 nm, using the Ronchi Test method as shown in FIG. 6. For the light source 11, an X-ray laser was used. Based on the results of these measurements, a respective contour line plot was generated for each multilayer mirror. The contour-line interval was set at 0.2 nm of surface height, which is equal to the correction of the profile of the reflective surface obtained by removing one layer-pair of the multilayer film. Based on their respective contour-line plots, selected regions of the surface of the multilayer films were removed layer-by-layer as required to correct the reflective surfaces. After correcting the multilayer mirrors, the wavefront aberration of each had been reduced to 0.15 nm RMS or less.

The corrected multilayer mirrors were assembled in a lens barrel and aligned with each other in a manner to minimize wavefront aberrations of the resulting projection-optical system. The obtained wavefront aberration of the system was 0.8 nm RMS, which was deemed sufficient for diffraction-limit imaging performance.

The projection-optical system thus fabricated was assembled in an EUV microlithography system, which was used for making test lithographic exposures. With the microlithography system, images of fine line-and-space patterns (having line and space widths as narrow as 30 nm) were resolved successfully.

Working Example 8

In this working example a subject EUV projection-optical system (as used in an EUV microlithography apparatus) comprised six aspherical multilayer mirrors. The projection-optical system had a numerical aperture (NA) of 0.25, a demagnification ratio of 4:1, and a ring-field exposure area. The aspherical multilayer mirrors were fabricated, using conventional surface-polishing process technology, to a profile accuracy of 0.5 nm RMS. The mirrors were assembled into the projection-optical system, which exhibited a wavefront aberration of 2.4 nm RMS. For satisfactory use at a wavelength of 13.4 nm, the wavefront aberration must be about 1 nm RMS or less. Hence, the profile accuracy of the mirrors was not acceptable.

To produce each multilayer mirror, a Mo/Si multilayer film was formed on the surface of an aspherical mirror substrate. First, a 50-layer multilayer film, in which d = 6.8 nm, was formed by ion-beam sputtering. Next, the wavefront profile of the reflective surface of each multilayer mirror was measured, at $\lambda$ = 13.4 nm, using the Hartmann Test method as shown in FIG. 8. For the light source 11, a laser-plasma source was used. Based on the results of these measurements, a respective contour line plot was generated for each multilayer mirror. The contour-line interval was set at 0.2 nm of surface height, which is equal to the correction of the profile of the reflective surface obtained by removing one layer-pair of the multilayer film. Based on their respective contour-line plots, selected regions of the surface of the multilayer films were removed layer-by-layer as required to correct the reflective surfaces. After correcting the multilayer mirrors, the wavefront aberration of each had been reduced to 0.15 nm RMS or less.

The corrected multilayer mirrors were assembled in a lens barrel and aligned with each other in a manner to minimize wavefront aberrations of the resulting projection-optical system. The obtained wavefront aberration of the system was 0.8 nm RMS, which was deemed sufficient for diffraction-limit imaging performance.

The projection-optical system thus fabricated was assembled in an EUV microlithography system, which was used for making test lithographic exposures. With the microlithography system, images of fine line-and-space patterns (having line and space widths as narrow as 30 nm) were resolved successfully.

Working Example 9

In this working example a subject EUV projection-optical system (as used in an EUV microlithography apparatus) comprised six aspherical multilayer mirrors. The projection-optical system had a numerical aperture (NA) of 0.25, a demagnification ratio of 4:1, and a ring-field exposure area. The aspherical multilayer mirrors were fabricated, using conventional surface-polishing process technology, to a profile accuracy of 0.5 nm RMS. The mirrors were assembled into the projection-optical system, which exhibited a wavefront aberration of 2.4 nm RMS. For satisfactory use at a wavelength of 13.4 nm, the wavefront aberration must be about 1 nm RMS or less. Hence, the profile accuracy of the mirrors was not acceptable.

To produce each multilayer mirror, a Mo/Si multilayer film was formed on the surface of an aspherical mirror substrate. First, a 50-layer multilayer film, in which d = 6.8 nm, was formed by ion-beam sputtering. Each multilayer mirror was installed in a lens barrel through which a transmitted wavefront was measured while adjusting for minimum wavefront aberrations. Measurement of the transmitted wavefront was performed at $\lambda$ = 13.4 nm using shearing interferometry as depicted in FIG. 10. The light source 11 used for this measurement was a laser-plasma light source. From the measured wavefront aberrations, corrections to the reflective surfaces of the multilayer mirrors were computed using optical-design software. Based on the results of these measurements, a respective contour line plot was generated for each mirror. The contour-line interval was set at 0.2 nm of surface height, which is equal to the correction of the profile of the reflective surface obtained by removing one layer-pair of the multilayer film. Based on their respective contour-line plots, selected regions of the surface of the multilayer films were removed layer-by-layer as required to correct the reflective surfaces. After correcting the multilayer mirrors, the wavefront aberration of each had been reduced to 0.15 nm RMS or less.

The corrected multilayer mirrors were assembled in a lens barrel and aligned with each other in a manner to minimize wavefront aberrations of the resulting projection-optical system. The obtained wavefront aberration of the system was 0.8 nm RMS, which was deemed sufficient for diffraction-limit imaging performance.

The projection-optical system thus fabricated was assembled in an EUV microlithography system, which was used for making test lithographic exposures. With the microlithography system, images of fine line-and-space patterns (having line and space widths as narrow as 30 nm) were resolved successfully.

Working Example 10

In this working example a subject EUV projection-optical system (as used in an EUV microlithography apparatus) comprised six aspherical multilayer mirrors. The projection-optical system had a numerical aperture (NA) of 0.25, a demagnification ratio of 4:1, and a ring-field exposure area. The aspherical multilayer mirrors were fabricated, using conventional surface-polishing process technology, to a profile accuracy of 0.5 nm RMS. The mirrors were assembled into the projection-optical system, which exhibited a wavefront aberration of 2.4 nm RMS. For satisfactory use at a wavelength of 13.4 nm, the wavefront aberration must be about 1 nm RMS or less. Hence, the profile accuracy of the mirrors was not acceptable.

To produce each multilayer mirror, a Mo/Si multilayer film was formed on the surface of an aspherical mirror substrate. First, a 50-layer multilayer film, in which d = 6.8 nm, was formed by ion-beam sputtering. Each multilayer mirror was installed in a lens barrel through which a transmitted wavefront was measured while adjusting for minimum wavefront aberrations. Measurement of the transmitted wavefront was performed at $\lambda$ = 13.4 nm using point-diffraction interferometry as depicted in FIG. 11. The light source used for this measurement was an undulator (a type of synchrotron-radiation light source). From the measured wavefront aberrations, corrections to the reflective surfaces of the multilayer mirrors were computed using optical-design software. Based on the results of these measurements, a respective contour line plot was generated for each mirror. The contour-line interval was set at 0.2 nm of surface height, which is equal to the correction of the profile of the reflective surface obtained by removing one layer-pair of the multilayer film. Based on their respective contour-line plots, selected regions of the surface of the multilayer films were removed layer-by-layer as required to correct the reflective surfaces. After correcting the multilayer mirrors, the wavefront aberration of each had been reduced to 0.15 nm RMS or less.

The corrected multilayer mirrors were assembled in a lens barrel and aligned with each other in a manner to minimize wavefront aberrations of the resulting projection-optical system. The obtained wavefront aberration of the system was 0.8 nm RMS, which was deemed sufficient for diffraction-limit imaging performance.

The projection-optical system thus fabricated was assembled in an EUV microlithography system, which was used for making test lithographic exposures. With the microlithography system, images of fine line-and-space patterns (having line and space widths as narrow as 30 nm) were resolved successfully.

Working Example 11

In this working example a subject EUV projection-optical system (as used in an EUV microlithography apparatus) comprised six aspherical multilayer mirrors. The projection-optical system had a numerical aperture (NA) of 0.25, a demagnification ratio of 4:1, and a ring-field exposure area. The aspherical multilayer mirrors were fabricated, using conventional surface-polishing process technology, to a profile accuracy of 0.5 nm RMS. The mirrors were assembled into the projection-optical system, which exhibited a wavefront aberration of 2.4 nm RMS. For satisfactory use at a wavelength of 13.4 nm, the wavefront aberration must be about 1 nm RMS or less. Hence, the profile accuracy of the mirrors was not acceptable.

To produce each multilayer mirror, a Mo/Si multilayer film was formed on the surface of an aspherical mirror substrate. First, a 50-layer multilayer film, in which d = 6.8 nm, was formed by ion-beam sputtering. Each multilayer mirror was installed in a lens barrel through which a transmitted wavefront was measured while adjusting for minimum wavefront aberrations. Measurement of the transmitted wavefront was performed at λ = 13.4 nm using the Foucalt Test method as depicted in FIG. 12. The light source 11 used for this measurement was a laser-plasma light source. From the measured wavefront aberrations, corrections to the reflective surfaces of the mirrors were computed using optical-design software. Based on the results of these measurements, a respective contour line plot was generated for each mirror. The contour-line interval was set at 0.2 nm of surface height, which is equal to the correction of the profile of the reflective surface obtained by removing one layer-pair of the multilayer film. Based on their respective contour-line plots, selected regions of the surface of the multilayer films were removed layer-by-layer as required to correct the reflective surfaces. After correcting the mirrors, the wavefront aberration of each had been reduced to 0.15 nm RMS or less.

The corrected multilayer mirrors were assembled in a lens barrel and aligned with each other in a manner to minimize wavefront aberrations of the resulting projection-optical system. The obtained wavefront aberration of the system was 0.8 nm RMS, which was deemed sufficient for diffraction-limit imaging performance.

The projection-optical system thus fabricated was assembled in an EUV microlithography system, which was used for making test lithographic exposures. With the microlithography system, images of fine line-and-space patterns (having line and space widths as narrow as 30 nm) were resolved successfully.

Working Example 12

In this working example a subject EUV projection-optical system (as used in an EUV microlithography apparatus) comprised six aspherical multilayer mirrors. The projection-optical system had a numerical aperture (NA) of 0.25, a demagnification ratio of 4:1, and a ring-field exposure area. The aspherical multilayer mirrors were fabricated, using conventional surface-polishing process technology, to a profile accuracy of 0.5 nm RMS. The mirrors were assembled into the projection-optical system, which exhibited a wavefront aberration of 2,4 nm RMS. For satisfactory use at a wavelength of 13.4 nm, the wavefront aberration must be about 1 nm RMS or less. Hence, the profile accuracy of the mirrors was not acceptable.

To produce each multilayer mirror, a Mo/Si multilayer film was formed on the surface of an aspherical mirror substrate. First, a 50-layer multilayer film, in which d = 6.8 nm, was formed by ion-beam sputtering. Each multilayer mirror was installed in a lens barrel through which a transmitted wavefront was measured while adjusting for minimum wavefront aberrations. Measurement of the transmitted wavefront was performed at λ = 13.4 nm using the Ronchi Test method as depicted in FIG. 13. The light source 11 used for this measurement was an electric-discharge-plasma light source. From the measured wavefront aberrations, corrections to the reflective surfaces of the multilayer mirrors were computed using optical-design software. Based on the results of these measurements, a respective contour line plot was generated for each mirror. The contour-line interval was set at 0.2 nm of surface height, which is equal to the correction of the profile of the reflective surface obtained by removing one layer-pair of the multilayer film. Based on their respective contour-line plots, selected regions of the surface of the multilayer films were removed layer-by-layer as required to correct the reflective surfaces. After correcting the multilayer mirrors, the wavefront aberration of each had been reduced to 0.15 nm RMS or less.

The corrected multilayer mirrors were assembled in a lens barrel and aligned with each other in a manner to minimize wavefront aberrations of the resulting projection-optical system. The obtained wavefront aberration of the system was 0.8 nm RMS, which was deemed sufficient for diffraction-limit imaging performance.

The projection-optical system thus fabricated was assembled in an EUV microlithography system, which was used for making test lithographic exposures. With the microlithography system, images of fine line-and-space patterns (having line and space widths as narrow as 30 nm) were resolved successfully.

Working Example 13

In this working example a subject EUV projection-optical system (as used in an EUV microlithography apparatus) comprised six aspherical multilayer mirrors. The projection-optical system had a numerical aperture (NA) of 0.25, a demagnification ratio of 4:1, and a ring-field exposure area. The aspherical multilayer mirrors were fabricated, using conventional surface-polishing process technology, to a profile accuracy of 0.5 nm RMS. The mirrors were assembled into the projection-optical system, which exhibited a wavefront aberration of 2.4 nm RMS. For satisfactory use at a wavelength of 13.4 nm, the wavefront aberration must be about 1 nm RMS or less. Hence, the profile accuracy of the mirrors was not acceptable.

To produce each multilayer mirror, a Mo/Si multilayer film was formed on the surface of an aspherical mirror substrate. First, a 50-layer multilayer film, in which d = 6.8 nm, was formed by ion-beam sputtering. Each mirror was installed in a lens barrel through which a transmitted wavefront was measured while adjusting for minimum wavefront aberrations. Measurement of the transmitted wavefront was performed at $\lambda$ = 13.4 nm using the Hartmann Test method as depicted in FIG. 14. The light source 11 used for this measurement was an X-ray laser. From the measured wavefront aberrations, corrections to the reflective surfaces of the multilayer mirrors were computed using optical-design software. Based on the results of these measurements, a respective contour line plot was generated for each mirror. The contour-line interval was set at 0.2 nm of surface height, which is equal to the correction of the profile of the reflective surface obtained by removing one layer-pair of the multilayer film. Based on their respective contour-line plots, selected regions of the surface of the multilayer films were removed layer-by-layer as required to correct the reflective surfaces. After correcting the multilayer mirrors, the wavefront aberration of each had been reduced to 0.15 nm RMS or less.

The corrected multilayer mirrors were assembled in a lens barrel and aligned with each other in a manner to minimize wavefront aberrations of the resulting projection-optical system. The obtained wavefront aberration of the system was 0.8 nm RMS, which was deemed sufficient for diffraction-limit imaging performance.

The projection-optical system thus fabricated was assembled in an EUV microlithography system, which was used for making test lithographic exposures. With the microlithography system, images of fine line-and-space patterns (having line and space widths as narrow as 30 nm) were resolved successfully.

Working Example 14

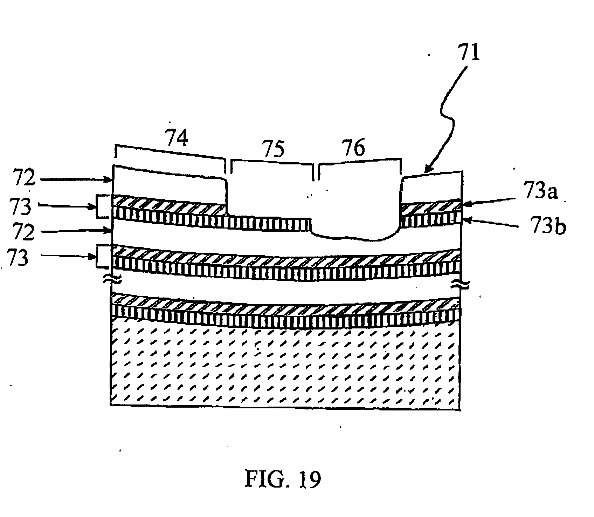

A multilayer mirror 71 was formed (FIG. 19) in which the period length of the multilayer film was 6.8 nm. In FIG. 19, the depicted number of layers is fewer than the actual number of layers. The layer pair comprising each period length was a 4.4-nm Si layer 72 and a 2.4-nm layer group 73. The topmost layer is a Si layer 72, and the individual layers 72, 73 were stacked in an alternating manner. Each layer group 73 comprised a respective sublayer pair consisting of one Ru sublayer 73a and one Mo sublayer 73b, wherein each sublayer had a thickness of 1.2 nm.

In the figure, the region 74 has not been subjected to RIE. The region 75 has been processed by RIE to remove the topmost Si layer 72 and the first Ru sublayer 73a. The region 76 has been processed by RIE to remove not only the topmost Si layer 72 and Ru sublayer 73a but also the first Mo sublayer 73b. In the region 76, RIE has progressed to about the middle of the second Si layer 72.

As described above, removal of the Si layer 72 in the region 75 provided no significant correction. The Ru sublayer 73a removed from the region 75 had a thickness of 1.2 nm, which provided (when removed) a correction of 0.1 nm of surface profile. Similarly, the sub-

layers 73a, 73b removed from the region 76 had a total thickness of 2.4 nm (not including the Si layer 72), which provided (when the sublayers 73a, 73b were removed) a correction of 0.2 nm of surface profile. Although the subsequent Si layer 72 is also removed to some extent from the region 76, the removed Si does not affect the wavefront aberration of the ML mirror. Since the units of correction (0.1 nm) achieved in this example are half the conventional units of 0.2 nm, this example provided a two-fold improvement, compared to conventional methods, in the accuracy of wavefront control.

When performing RIB to remove surficial material in this example, oxygen gas was used to remove the Ru sublayer 73a. The etching of the Ru sublayer 73a stopped when etching reached the underlying Mo sublayer 73b. Thus, the removal of surficial material was controlled. To remove the Mo sublayer 73b, $CF_4$ gas was used. Although RIE using $CF_4$ progressed into the underlying Si layer 72 to some extent, no adverse effect was realized with respect to wavefront correction.

During RIE, the reactive gas was ionized and irradiated, resulting in a fixed direction of motion of the ions formed from the gas. Hence, regions of the surface of the multilayer film on the mirror 71 that were not to be processed by RIE were shielded with a mask. As a result, ions were irradiated only on regions that were processed by RIE. Thus, it was easy to effect processing differences among the regions 74, 75, and 76.

The corrected multilayer mirrors were assembled into an optical system of an EUV microlithography system. Using the corrected system, a line-and-space pattern resolution as small as 30 nm was observed.

Working Example 15

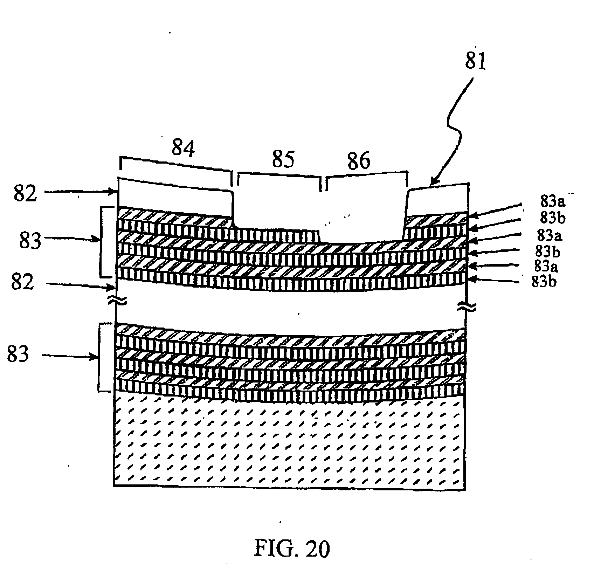

A multilayer mirror 81 was formed (FIG. 20) in which the period length of the multilayer film was 6.8 nm. In FIG. 20, the depicted number of layers is fewer than the actual number of layers. The layer pair comprising each period length was a 4.4-nm Si layer 82 and a 2.4-nm layer group 83. The topmost layer is a Si layer 82, and the individual layers 82, 83 were stacked in an alternating manner. Each layer group 83 comprised three respective sublayer pairs each consisting of one Ru sublayer 83a and one Mo sublayer 83b, wherein each sublayer had a thickness of 0.4 nm.

In the figure, the region 84 has not been subjected to RIE. The region 85 has been processed by RIE to remove the topmost Si layer 82 and the first Ru sublayer 83a. The region 86 has been processed by RIE to remove not only the topmost Si layer 82 and Ru sublayer 83a but also the first Mo sublayer 83b. In the region 86, RIE has progressed to the next Ru sublayer 83a.

As described above, removal of the Si layer 82 in the region 85 provided no significant correction. The Ru sublayer 83a removed from the region 85 had a thickness of 0.4 nm, which provides (when removed) a correction of 0.03 nm of surface profile. Similarly, the sublayers 83a, 83b removed from the region 86 had a total thickness of 0.8 run (not including the Si layer 82), which provided (when the sublayers 83a, 83b were removed) a correction of 0.067 nm of surface profile. Since the units of correction achieved in this example are one-sixth the conventional units of 0.2 nm, this example provided a six-fold improvement, compared to conventional methods, in the accuracy of wavefront control.

When performing RIE to remove surficial material in this example, oxygen gas was used to remove the Ru sublayer 83a. The etching of the Ru sublayer 83a stopped when etching reached the underlying Mo sublayer 83b. Thus, the removal of surficial material was controlled. To remove the Mo sublayer 83b, chlorine gas was used. RIE using chlorine gas stopped after progressing to the next underlying Ru sublayer 83a.

During RIE, the reactive gas was ionized and irradiated, resulting in a fixed direction of motion of the ions formed from the gas. Hence, regions of the surface of the multilayer film on the mirror 81 that were not to be processed by RIE were shielded with a mask. As a result, ions were irradiated only on regions that were processed by RIE. Thus, it was easy to effect processing differences among the regions 84, 85, and 86.

The corrected multilayer mirrors were assembled into an optical system of an EUV microlithography system. Using the corrected system, a line-and-space pattern resolution as small as 30 nm was observed.

Working Example 16

In this working example a subject EUV projection-optical system (as used in an EUV microlithography apparatus) comprised six aspherical multilayer mirrors. The projection-optical system had a numerical aperture (NA) of 0.25, a demagnification ratio of 4:1, and a ring-field exposure area. The aspherical multilayer mirrors were fabricated, using conventional surface-polishing process technology, to a profile accuracy of 0.5 nm RMS. The mirrors were assembled into the projection-optical system, which exhibited a wavefront aberration of 2.4 nm RMS. For satisfactory use at a wavelength of 13.4 nm, the wavefront aberration must be about 1 nm RMS or less. Hence, the profile accuracy of the mirrors was not acceptable.

To produce each multilayer mirror, a Mo/Si multilayer film was formed on the surface of an aspherieal mirror substrate. The multilayer film was in two portions. The first portion had a period length d = 6.8 nm, $\Gamma_1 = 1/3$, and $N_1 = 40$ layer pairs. The second portion, formed superposedly over the first portion, had a period length d = 6.8 nm, $\Gamma_2 = 0.1$, and $N_2 = 10$ layer pairs. The multilayer films were grown by ion-beam sputtering.

The reflection-wavefront profile of each multilayer mirror was measured as described above and corrected as required by removing one or more surficial layers of the respective multilayer film layer-by-layer in selected regions. Removing one layer of the second portion of the multilayer film (of which $\Gamma_2 = 0.1$) resulted in a change of only 0.05 nm in the optical path length. By correcting the multilayer mirrors in this manner, the wavefront profile of each mirror was corrected to within 0.15 nm RMS.

The multilayer mirrors were installed in a lens barrel through which a transmitted wavefront was measured while adjusting for minimum wavefront aberrations. The measurement of transmitted wavefront was performed at $\lambda = 13.4$ nm using the Hartmann Test method as depicted in FIG. 14. The light source used for this measurement was an X-ray laser. From the measured wavefront aberrations, corrections to the reflective surfaces of the multilayer mirrors were computed using optical-design software. Based on the results of these measurements, a respective contour line plot was generated for each multilayer mirror. The contour-line interval was set at 0.2 nm of surface height, which is equal to the correction of the profile of the reflective surface obtained by removing one layer-pair of the multilayer film. Based on their respective contour-line plots, selected regions of the surface of the multilayer films were removed layer-by-layer as required to correct the reflective surfaces. After correcting the multilayer mirrors, the wavefront aberration of each had been reduced to 0.15 nm RMS or less.

The corrected multilayer mirrors were assembled in a lens barrel and aligned with each other in a manner to minimize wavefront aberrations of the resulting projection-optical system. The obtained wavefront aberration of the system was 0.8 nm RMS, which was deemed sufficient for diffraction-limit imaging performance.

The projection-optical system thus fabricated was assembled in an EUV microlithography system, which was used for making test lithographic exposures. With the microlithography system, images of fine line-and-space patterns (having line and space widths as narrow as 30 nm) were resolved successfully.

Whereas the invention has been described in connection with multiple representative embodiments and examples, it will be understood that the invention is not limited to those embodiments and examples. On the contrary, the invention is intended to encompass all modifications, alternatives, and equivalents as may be included within the spirit and scope of the invention, as defined by the appended claims.

The features disclosed in the foregoing description, in the claims and/or in the accompanying drawings may, both separately and in any combination thereof, be material for realising the invention in diverse forms thereof.

**Claims**

1.  In a method for making a multilayer mirror, wherein a stack of alternatingly superposed layers of first and second materials is formed on a surface of a mirror substrate, and the first and second materials have different respective refractive indices with respect to EUV radiation, a method for reducing wavefront aberrations of EUV radiation reflected from a surface of the multilayer mirror, comprising:

at an EUV wavelength at which the multilayer mirror is to be used, measuring a profile of a reflected wavefront from the surface to obtain a map of the surface indicating regions targeted for surficial removal of one or more layers of the multilayer film necessary to reduce wavefront aberrations of EUV light reflected from the surface; and
based on the map, removing one or more surficial layers in the indicated regions.

2. The method of claim 1, wherein the measuring step is performed using a diffractive optical element.

3. The method of claim 2, wherein the measuring step is performed by a technique selected from the group consisting of shearing interferometry, point-diffraction interferometry, a Foucalt test, a Ronchi test, and a Hartmann Test.

4. In a method for making a multilayer mirror, wherein a stack of alternating layers of first and second materials is formed on a surface of a mirror substrate, and the first and second materials have different respective refractive indices with respect to EUV radiation, a method for reducing wavefront aberrations of EUV radiation reflected from a surface of the multilayer mirror, comprising:

placing the multilayer mirror in an EUV optical system transmissive to EUV radiation at a wavelength at which the multilayer mirror is to be used;
at the EUV wavelength at which the multilayer is to be used, measuring a profile of a wavefront transmitted through the EUV optical system to obtain a map of the surface indicating regions targeted for surficial removal of one or more layers of the multilayer film necessary to reduce wavefront aberrations of EUV light reflected from the surface; and
based on the map, removing one or more surficial layers in the indicated regions.

5. The method of claim 4, wherein the measuring step is performed using a diffractive optical element.

6. The method of claim 5, wherein the measuring step is performed by a technique selected from the group consisting of shearing interferometry, point-diffraction interferometry, a Foucalt test, a Ronchi test, and a Hartmann Test.

7. The method of claim 4, wherein multiple respective multilayer mirrors are placed in the EUV optical system.

8. A method for making a multilayer mirror for use in an EUV optical system, comprising:

forming a stack of alternating layers of superposed first and second materials on a surface of a mirror substrate, the first and second materials having different respective refractive indices with respect to EUV radiation;
at an EUV wavelength at which the multilayer mirror is to be used, measuring a profile of a reflected wavefront from the surface to obtain a map of the surface indicating regions targeted for surficial removal of one or more layers of the multilayer film necessary to reduce wavefront aberrations of EUV light reflected from the surface; and
based on the map, removing one or more surficial layers in the indicated regions.

9. The method of claim 8, wherein the forming step comprises forming a stack of layer pairs each comprising a layer of a material comprising Mo and a layer of a material comprising Si, the layers in the stack being superposed in alternating order.

10. The method of claim 9, wherein each layer pair has a period in a range of 6 to 12 nm.

11. The method of claim 8, wherein the measuring step is performed using a diffractive optical element.

12. The method of claim 11, wherein the measuring step is performed by a technique selected from the group consisting of shearing intcrferometry, point-diffraction interferometry, a Foucalt test, a Ronchi test, and a Hartmann Test.

13. A multilayer mirror, manufactured by a method according to claim 1.

14. A multilayer mirror, manufactured by a method according to claim 4.

15. A multilayer mirror, manufactured by a method according to claim 8.

16. An EUV optical system, comprising at least one multilayer mirror as recited in claim 13.

17. An EUV optical system, comprising at least one multilayer mirror as recited in claim 14.

**18.** An EUV optical system, comprising at least one multilayer mirror as recited in claim 15.

**19.** An EUV microlithography apparatus, comprising an EUV optical system as recited in claim 16.

**20.** An EUV microlithography apparatus, comprising an EUV optical system as recited in claim 17.

**21.** An EUV microlithography apparatus, comprising an EUV optical system as recited in claim 18.

**22.** A multilayer mirror that is reflective to incident EUV radiation, comprising:

a mirror substrate; and
a thin-film layer stack formed on a surface of the mirror substrate, the stack including multiple thin-film first layer groups and multiple thin-film second layer groups alternatingly superposed relative to each other in a periodically repeating manner, each first layer group including at least one sublayer of a first material having a refractive index to EUV light substantially equal to the refractive index of a vacuum, and each second layer group including at least one sublayer of a second material and at least one sublayer of a third material, the first and second layer groups being alternatingly superposed relative to each other in a periodically repeating configuration, the second and third materials having respective refractive indices that are substantially similar to each other but different from the refractive index of the first material sufficiently such that the stack is reflective to incident EUV light, and the second and third materials having differential reactivities to sublayer-removal conditions such that a first sublayer-removal condition will remove a sublayer of the second material preferentially without substantial removal of an underlying sublayer of the third material, and a second sublayer-removal condition will remove a sublayer of the third material preferentially without substantial removal of an underlying sublayer of the second material.

**23.** The multilayer mirror of claim 22, wherein the second material comprises Mo and the third material comprises Ru.

**24.** The multilayer mirror of claim 22, wherein the first material comprises Si.

**25.** The multilayer mirror of claim 22, wherein each second layer group comprises multiple sublayer sets each comprising a sublayer of the second material and a sublayer of the third material, the sublayers being alternatingly stacked to form the second layer group.

**26.** A method for making a multilayer mirror for use in an EUV optical system, comprising:

on a surface of a mirror substrate, forming a thin-film layer stack including multiple thin-film first layer groups and multiple thin-film second layer groups alternatingly superposed relative to each other in a periodically repeating configuration, each first layer group including at least one sublayer of a first material having a refractive index to EUV light substantially equal to the refractive index of a vacuum, and each second layer group including at least one sublayer of a second material and at least one sublayer of a third material, the first and second layer groups being alternatingly superposed relative to each other in a periodically repeating configuration, the second and third materials having respective refractive indices that are substantially similar to each other but different from the refractive index of the first material sufficiently such that the stack is reflective to incident EUV light, and the second and third materials having differential reactivities to sublayer-removal conditions such that a first sublayer-removal condition will preferentially remove a sublayer of the second material without substantial removal of an underlying sublayer of the third material, and a second sublayer-removal condition will preferentially remove a sublayer of the third material without substantial removal of an underlying sublayer of the second material; and
in selected regions of a surficial second layer group, removing one or more sublayers of the surficial second layer group so as to reduce wavefront aberrations of EUV radiation reflected from the surface.

**27.** The method of claim 26, wherein removing one or more sublayers of the surficial second layer group yields a phase difference in EUV components reflected from the indicated regions, compared to EUV light reflected from other regions in which no sublayers are removed or a different number of sublayers are removed.

**28.** The method of claim 26, wherein removing one or more sublayers of the surficial second group layer comprises selectively exposing the indicated regions to one or both the first and second sublayer-removal conditions as required to achieve an indicated change in a reflected wavefront profile from the surface.

**29.** The method of claim 26, further comprising the step of measuring a profile of a reflected wavefront from the surface to obtain a map of the surface indicated the regions targeted for removal of the one or more sublayers of the surficial second layer group.

**30.** A multilayer mirror, produced using a method as recited in claim 26.

**31.** An EUV optical system, comprising at least one multilayer mirror as recited in claim 30.

**32.** An EUV microlithography apparatus, comprising an EUV optical system as recited in claim 31.

**33.** An EUV optical system, comprising at least one multilayer mirror as recited in claim 22.

**34.** An EUV microlithography apparatus, comprising an EUV optical system as recited in claim 33.

**35.** A multilayer mirror that is reflective to incident EUV radiation, comprising:

a mirror substrate; and
a thin-film layer stack formed on a surface of the mirror substrate, the stack including superposed first and second groups of multiple thin-film layers, each of the first and second groups comprising respective first and second layers alternatingly superposed relative to each other in a respective periodically repeating manner, each first layer comprising a first material having a refractive index to EUV light substantially equal to the refractive index of a vacuum, and each second layer comprising a second material having a refractive index that is different from the refractive index of the first material sufficiently such that the stack is reflective to incident EUV light, the first and second groups having similar respective period lengths but having different respective thickness ratios of individual respective first and second layers.

**36.** The multilayer mirror of claim 35, wherein the first material is Si and the second material is selected from the group consisting of Mo and Ru.

**37.** The multilayer mirror of claim 35, wherein the respective period lengths are within a range of 6 to 12 nm.

**38.** The multilayer mirror of claim 35, wherein:

$\Gamma_1$ denotes a ratio of a respective second-layer thickness to the period length of the first group;
$\Gamma_2$ denotes a ratio of a respective second-layer thickness to the period length of the second group; and

$\Gamma_2 < \Gamma_1$.

**39.** The multilayer mirror of claim 38, wherein $\Gamma_2$ is established such that, whenever a reflection-wavefront correction is made to the mirror by removing one or more surficial layers of the mirror, the magnitude of the correction per unit thickness of the second material is as prescribed.

**40.** A method for making a multilayer mirror for use in an EUV optical system, comprising:

on a surface of a mirror substrate, forming a stack including a first group of multiple superposed thin-film layers and a superposed second group of multiple superposed thin-film layers, each of the first and second groups comprising respective first and second layers alternatingly superposed on each other in a respective periodically repeating configuration, each first layer comprising a first material having a refractive index to EUV light substantially equal to the refractive index of a vacuum, and each second layer comprising a second material having a refractive index that is different from the refractive index of the first material sufficiently such that the stack is reflective to incident EUV light, the first and second groups having similar respective period lengths but having different respective thickness ratios of individual respective first and second layers; and
in selected regions of a surface of the stack, removing one or more layers of a surficial second group so as to reduce wavefront aberrations of EUV light reflected from the surface.

**41.** The method of claim 40, further comprising the step of measuring a profile of a reflected wavefront from the surface to obtain a map of the surface indicating regions targeted for removal of one or more layers of the surficial second layer group as necessary to reduce wavefront aberrations of EUV light reflected from the surface.

**42.** The method of claim 40, wherein, in the stack-forming step, $\Gamma_1$ denotes a ratio of a respective second-layer thickness to the period length of the first group;
$\Gamma_2$ denotes a ratio of a respective second-layer thickness to the period length of the second group; and
$\Gamma_2 < \Gamma_1$.

**43.** The method of claim 42, wherein $\Gamma_2$ is established such that, in the layer-removal step performed to make a reflection-wavefront correction, the magnitude of the correction per unit thickness of the second material is as prescribed.

**44.** The method of claim 40, wherein, in the stack-forming step and during formation of the second group of layers, the second group is formed having a number of respective second layers such that, during the layer-removal step, removing a surficial second layer results in a maximal phase correction of a reflection wavefront from the mirror.

**45.** The method of claim 40, wherein the first material is Si and the second material is selected from the group consisting of Mo and Ru.

**46.** The method of claim 40, wherein the respective period lengths are in a range of 6 to 12 nm.

**47.** The method of claim 40, further comprising the step, after the layer-removal step, of forming a surficial layer of a reflectivity-correcting material, having a refractive index to EUV light substantially equal to the refractive index of a vacuum, at least in regions in which reflectivity has changed due to removal of one or more surficial layers during the layer-removal step.

**48.** The method of claim 47, wherein the reflectivity-correcting material comprises Si.

**49.** A multilayer mirror, produced using a method as recited in claim 41.

**50.** An EUV optical system, comprising at least one multilayer mirror as recited in claim 49.

**51.** An EUV microlithography apparatus, comprising an EUV optical system as recited in claim 50.

**52.** An EUV optical system, comprising at least one multilayer mirror as recited in claim 35.

**53.** An EUV microlithography apparatus, comprising an EUV optical system as recited in claim 52.

**54.** A multilayer mirror, comprising:

a mirror substrate;
a stack of alternatingly superposed layers of first and second materials formed on a surface of the mirror substrate, the first and second materials having different respective refractive indices with respect to EUV radiation, wherein selected regions of the multilayer mirror have been subjected to surficial-layer shaving so as to correct a reflected-wavefront profile from the mirror; and
a cover layer formed on a surface of the stack, the cover layer being of a material exhibiting a persistent and consistently high transmissivity to electromagnetic radiation of a specified wavelength, the cover layer extending over regions of the surface of the stack including the selected regions and having a substantially uniform thickness.

**55.** The multilayer mirror of claim 54, wherein the stack has a period length in a range of 6 to 12 nm.

**56.** The multilayer mirror of claim 54, wherein:

the first material is Si or an alloy including Si;
the second material is Mo or an alloy including Mo; and
the material of the cover layer is Si or an alloy including Si.

**57.** The multilayer mirror of claim 56, wherein the cover layer has a thickness of 1 to 3 nm or a thickness sufficient to add 1-3 nm to a period length of a surficial pair of layers including a respective layer of the first material and a respective layer of the second material.

**58.** A method for making a multilayer mirror for use in an EUV optical system, comprising:

on a surface of a mirror substrate, forming a thin-film layer stack including multiple layers of a first material and multiple layers of a second material alternating superposed relative to one another in a periodically repeating manner, the first and second materials having different respective refractive indices with respect to EUV radiation;
removing one or more surficial layers from selected surficial regions of the multilayer mirror so as to correct a reflected-wavefront profile from the mirror; and
forming a cover layer on a surface of the stack, the cover layer being of a material exhibiting a persistent and consistently high transmissivity to electromagnetic radiation of a specified wavelength, the cover layer extending over regions of the surface of the stack including the selected surficial regions and having a substantially uniform thickness.

**59.** The method of claim 58, wherein the stack is formed with a period length in a range of 6 to 12 nm.

**60.** The method of claim 58, wherein:

the first material is Si or an alloy including Si;
the second material is Mo or an alloy including Mo; and
the material of the cover layer is Si or an alloy including Si.

**61.** The method of claim 58, wherein the cover layer is formed having a thickness of 1 to 3 nm or a thickness sufficient to add 1-3 nm to a period length of a surficial pair of layers including a respective layer of the first material and a respective layer of the second material.

**62.** A multilayer mirror, produced using a method as recited in claim 58.

**63.** An EUV optical system, comprising at least one multilayer mirror as recited in claim 62.

**64.** An EUV microlithography apparatus, comprising an EUV optical system as recited in claim 63.

**65.** An EUV optical system, comprising at least one multilayer mirror as recited in claim 54.

**66.** An EUV microlithography apparatus, comprising an EUV optical system as recited in claim 65.

**67.** A method for making a multilayer mirror, comprising:

on a surface of a mirror substrate, forming a stack of alternating layers of first and second materials having different respective refractive indices with respect to EUV radiation, the stack having a prescribed period length; and in selected regions of a surface of the stack, removing one or more surficial layer pairs as required to correct a reflected-wavefront profile of the surface, in a manner such that edges of remaining corresponding layer pairs located outside the selected regions have a smoothly graded topology.

**68.** The method of claim 67, wherein the layer-pair-removal step comprises a technique selected from the group consisting of small-tool corrective machining, ion-beam processing, and chemical-vapor machining.

**69.** The method of claim 67, wherein the first material comprises Si and the second material comprises a material selected from the group consisting of Mo and Ru.

**70.** The method of claim 67, wherein the period length is in a range of 6 to 12 nm.

**71.** A multilayer mirror, produced using a method as recited in claim 67.

**72.** An EUV optical system, comprising a multilayer mirror as recited in claim 71.

**73.** An EUV microlithography system, comprising an EUV optical system as recited in claim 72.

28

FIG. 1(A)

FIG. 1(B)

FIG. 1(C)

FIG. 2

FIG. 3

EP 1 306 698 A1

FIG. 4

FIG. 5

EP 1 306 698 A1

FIG. 6

EP 1 306 698 A1

FIG. 7

FIG. 8

FIG. 9

FIG. 10

FIG. 11

EP 1 306 698 A1

FIG. 12

FIG. 13

FIG. 14

44    43

FIG. 15(A)

42 { A
     B
     A
     B

~ 41

45
46

42 {

FIG. 15(B)

PRIOR ART

~ 41

FIG. 16(A)

FIG. 16(B)

EP 1 306 698 A1

FIG. 17(A)

FIG. 17(B)

FIG. 18(A)

FIG. 18(B)

FIG. 19

FIG. 20

FIG. 21

FIG. 22

FIG. 23

FIG. 24

FIG. 25(A)

FIG. 25(B)

FIG. 26

FIG. 27

FIG. 28

FIG. 29(B)
PRIOR ART

FIG. 29(A)
PRIOR ART

FIG. 30(A)
PRIOR ART

Extent of Correction
Due to Removal of
Pairs of Film Layers

FIG. 30(B)

PRIOR ART

Extent of Correction
Due to Removal of
a Pair of Film Layers

FIG. 30(C)

47

FIG. 31(A)

PRIOR ART

FIG. 31(B)

PRIOR ART

**European Patent Office**

## PARTIAL EUROPEAN SEARCH REPORT

Application Number

which under Rule 45 of the European Patent Convention EP 01 12 5639
shall be considered, for the purposes of subsequent
proceedings, as the European search report

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | YAMAMOTO M: "Sub-nm figure error correction of an extreme ultraviolet multilayer mirror by its surface milling" NUCLEAR INSTRUMENTS & METHODS IN PHYSICS RESEARCH, SECTION - A: ACCELERATORS, SPECTROMETERS, DETECTORS AND ASSOCIATED EQUIPMENT, NORTH-HOLLAND PUBLISHING COMPANY. AMSTERDAM, NL, vol. 467-468, 21 July 2001 (2001-07-21), pages 1282-1285, XP004298944 ISSN: 0168-9002 * the whole document * --- | 1-3,13 | G02B5/08 G02B5/10 G21K1/06 |
| X | EP 1 152 435 A (TOHOKU TECHNO ARCH CO LTD) 7 November 2001 (2001-11-07) * column 3, line 17 - line 26 * * column 12, line 7 - line 12 * * claim 8 * & WO 01 41155 A 7 June 2001 (2001-06-07) --- -/-- | 1-3,13 | |

| TECHNICAL FIELDS SEARCHED (Int.Cl.7) |
|---|
| G02B G21K B23B |

### INCOMPLETE SEARCH

The Search Division considers that the present application, or one or more of its claims, does/do not comply with the EPC to such an extent that a meaningful search into the state of the art cannot be carried out, or can only be carried out partially, for these claims.

Claims searched completely :

Claims searched incompletely :

Claims not searched :

Reason for the limitation of the search:

see sheet C

| Place of search | Date of completion of the search | Examiner |
|---|---|---|
| THE HAGUE | 6 May 2002 | Ward, S |

EPO FORM 1503 03 82 (P04C07)

**European Patent Office**

**INCOMPLETE SEARCH**
**SHEET C**

Application Number

EP 01 12 5639

```
Claim(s) searched completely:
      1-3,13

Claim(s) searched incompletely:
      4-12,14-73

Reason for the limitation of the search:

The large number of claims presently on file (73) render it difficult, if
not impossible, to determine the matter for which protection is sought,
and hence the present application fails to comply with the clarity and
conciseness requirements of Article 84 EPC (see also Rule 29(5) EPC) to
such an extent that a meaningful search is impossible. Consequently, the
search has been carried out for those parts of the application which do
appear to be clear and concise, namely claims 1-3 and 13
```

**EP 1 306 698 A1**

**European Patent Office**

**PARTIAL EUROPEAN SEARCH REPORT**

Application Number

EP 01 12 5639

| | DOCUMENTS CONSIDERED TO BE RELEVANT | | CLASSIFICATION OF THE APPLICATION (Int.Cl.7) |
|---|---|---|---|
| Category | Citation of document with indication, where appropriate, of relevant passages | Relevant to claim | |
| A | CHENG-CHUNG LEE ET AL: "MAKING ASPHERICAL MIRRORS BY THIN-FILM DEPOSITION" APPLIED OPTICS, OPTICAL SOCIETY OF AMERICA,WASHINGTON, US, vol. 32, no. 28, 1 October 1993 (1993-10-01), pages 5535-5540, XP000398554 ISSN: 0003-6935 * the whole document * ----- | 1 | |
| | | | **TECHNICAL FIELDS SEARCHED** (Int.Cl.7) |

EPO FORM 1503 03.82 (P04C10)

62

**ANNEX TO THE EUROPEAN SEARCH REPORT
ON EUROPEAN PATENT APPLICATION NO.**          EP 01 12 5639

This annex lists the patent family members relating to the patent documents cited in the above-mentioned European search report.
The members are as contained in the European Patent Office EDP file on
The European Patent Office is in no way liable for these particulars which are merely given for the purpose of information.

06-05-2002

| Patent document cited in search report | | Publication date | Patent family member(s) | | Publication date |
|---|---|---|---|---|---|
| EP 1152435 | A | 07-11-2001 | AU | 2807401 A | 12-06-2001 |
| | | | EP | 1152435 A1 | 07-11-2001 |
| | | | WO | 0141155 A1 | 07-06-2001 |